# EUROPEAN PATENT SPECIFICATION

(11) **EP 4 235 792 B1**
(45) Date of publication and mention of the grant of the patent: **23.10.2024**
(21) Application number: 23158050.7
(22) Date of filing: 22.02.2023
(51) Int. Cl.: H01L 27/146

(54) **IMAGE SENSOR**
BILDSENSOR
CAPTEUR D'IMAGE

(30) Priority: 24.02.2022 KR 20220024283; 09.05.2022 KR 20220056596
(43) Date of publication of application: 30.08.2023
(73) Proprietor: Samsung Electronics Co., Ltd., Suwon-si, Gyeonggi-do 16677 (KR)
(72) Inventor: BAEK, Seungki, 16677 Suwon-si (KR); LEE, Kyungho, 16677 Suwon-si (KR); JUNG, Taesub, 16677 Suwon-si (KR); JUNG, Seungki, 16677 Suwon-si (KR); PYO, Junghyung, 16677 Suwon-si (KR)
(74) Representative: Marks & Clerk LLP

(56) References cited:
- EP-A1- 2 346 079
- EP-A2- 3 598 499
- US-A1- 2015 115 291
- US-A1- 2020 279 877
- US-A1- 2021 159 265

## Description

### BACKGROUND OF THE INVENTION

The present disclosure relates to an image sensor, and more particularly, to a CMOS image sensor.

An image sensor is a semiconductor device for converting an optical image into electrical signals. As computer and communication industries have been developed, high-performance image sensors have been increasingly demanded in various fields such as a digital camera, a camcorder, a personal communication system (PCS), a game console, a security camera, and a medical micro camera. Image sensors may be categorized as any one of charge coupled device (CCD) image sensors and complementary metal-oxide-semiconductor (CMOS) image sensors. CIS is short for the CMOS image sensor. The CIS may include a plurality of pixels arranged two-dimensionally. Each of the pixels may include a photodiode (PD). The photodiode may convert incident light into an electrical signal. The plurality of pixels may be defined by a deep device isolation pattern disposed therebetween. Document EP 3 598 499 shows an example of an image sensor according to the prior art.

### SUMMARY

Embodiments of the inventive concepts may provide an image sensor capable of improving charge transfer characteristics of a unit pixel.

Embodiments of the inventive concepts may also provide an image sensor capable of increasing a charge storage capacity (or full well capacity) of a unit pixel.

In an aspect, an image sensor may include a substrate including a pixel region, the substrate extending in a first direction and a second direction intersecting the first direction; a first photoelectric conversion region and a second photoelectric conversion region which are disposed in the pixel region of the substrate and are adjacent to each other in a first direction; a deep device isolation pattern penetrating the substrate in a third direction perpendicular to the first direction and the second direction, and surrounding the pixel region, the deep device isolation pattern comprising first extensions extending in the second direction between the first photoelectric conversion region and the second photoelectric conversion region, and the first extensions spaced apart from each other in the second direction; a plurality of first transfer gate electrodes disposed on the pixel region of the substrate and vertically overlapping with the first photoelectric conversion region in the third direction; and a plurality of second transfer gate electrodes disposed on the pixel region of the substrate and vertically overlapping with the second photoelectric conversion region in the third direction. The first photoelectric conversion region may extend in the second direction under the plurality of first transfer gate electrodes.

In an aspect, an image sensor may include a substrate having a first surface and a second surface which are opposite to each other, the substrate comprising a pixel region, the substrate extending in a first direction and a second direction intersecting the first direction; a deep device isolation pattern penetrating the substrate in a third direction perpendicular to the first direction and the second direction, the deep device isolation pattern surrounding the pixel region along the first direction and the second direction; a first photoelectric conversion region and a second photoelectric conversion region which are disposed in the pixel region of the substrate and are adjacent to each other in the first direction, the deep device isolation pattern comprising first extensions extending in the second direction between the first photoelectric conversion region and the second photoelectric conversion region, and the first extensions spaced apart from each other in the second direction; a plurality of first transfer gate electrodes disposed on the pixel region of the substrate and on the first photoelectric conversion region; and a plurality of second transfer gate electrodes disposed on the pixel region of the substrate and on the second photoelectric conversion region. The first photoelectric conversion region may extend in the second direction from a side of one of the first extensions to a side of another of the first extensions. The second photoelectric conversion region may extend in the second direction from another side of the one of the first extensions to another side of the another of the first extensions.

At least some of the above and other features of the invention are set out in the claims.

### BRIEF DESCRIPTION OF THE DRAWINGS

FIG. 1 is a block diagram schematically illustrating an image sensor according to some embodiments of the inventive concepts.
FIG. 2 is a circuit diagram illustrating a unit pixel of an image sensor according to some embodiments of the inventive concepts.
FIG. 3 is a plan view illustrating an image sensor according to some embodiments of the inventive concepts.
FIG. 4 is a plan view in which some components of FIG. 3 are omitted.
FIGS. 5A and 5B are cross-sectional views taken along lines A-A' and B-B' of FIG. 3, respectively.
FIG. 6 is a plan view illustrating an image sensor according to some embodiments of the inventive concepts.
FIG. 7 is a plan view in which some components of FIG. 6 are omitted.
FIGS. 8A, 8B, 8C and 8D are cross-sectional views taken along lines A-A', B-B', C-C' and D-D' of FIG. 6, respectively.
FIG. 9 is a plan view illustrating an image sensor according to some embodiments of the inventive concepts.
FIG. 10 is a plan view in which some components of FIG. 9 are omitted.
FIG. 11 is a cross-sectional view taken along a line C-C' of FIG. 9.
FIGS. 12 and 13 are cross-sectional views corresponding to the line C-C' of FIG. 9 to illustrate image sensors according to some embodiments of the inventive concepts.
FIG. 14 is a plan view illustrating an image sensor according to some embodiments of the inventive concepts.
FIG. 15 is a plan view in which some components of FIG. 14 are omitted.
FIG. 16 is a cross-sectional view taken along a line C-C' of FIG. 14.
FIGS. 17 and 18 are cross-sectional views corresponding to the line C-C' of FIG. 14 to illustrate image sensors according to some embodiments of the inventive concepts.
FIGS. 19A to 21A are cross-sectional views corresponding to the line A-A' of FIG. 3 to illustrate a method of manufacturing an image sensor according to some embodiments of the inventive concepts.
FIGS. 19B to 21B are cross-sectional views corresponding to the line B-B' of FIG. 3 to illustrate a method of manufacturing an image sensor according to some embodiments of the inventive concepts.
FIG. 22 is a plan view illustrating an image sensor according to some embodiments of the inventive concepts.
FIG. 23 is a cross-sectional view taken along a line I-I' of FIG. 22.

### DETAILED DESCRIPTION

Example embodiments of the inventive concepts will now be described more fully with reference to the accompanying drawings.

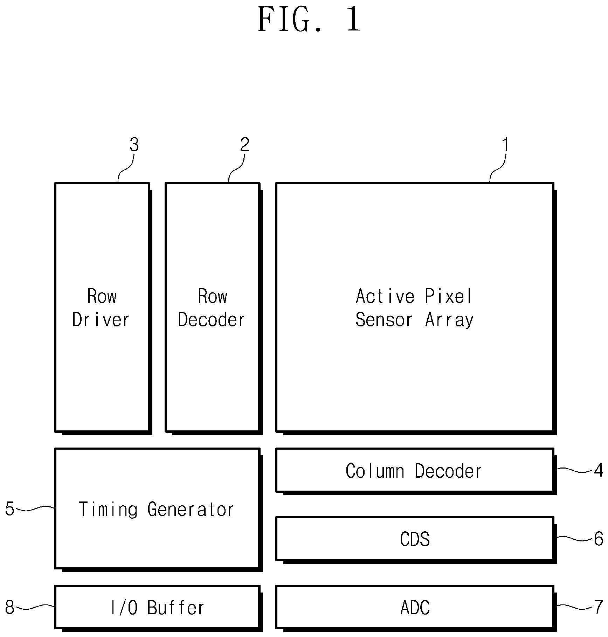

FIG. 1 is a block diagram schematically illustrating an image sensor according to some embodiments of the inventive concepts.

Referring to FIG. 1, an image sensor may include an active pixel sensor array 1, a row decoder 2, a row driver 3, a column decoder 4, a timing generator 5, a correlated double sampler (CDS) 6, an analog-to-digital converter (ADC) 7, and an input/output (I/O) buffer 8.

The active pixel sensor array 1 may include a plurality of pixels arranged two-dimensionally and may convert optical signals into electrical signals. A pixel, or unit pixel refers to a sensor element of an image sensor, and may refer to a smallest addressable light-sensing element of the image sensor. The active pixel sensor array 1 may be driven by a plurality of driving signals (e.g., a pixel selection signal, a reset signal, and a charge transfer signal) provided from the row driver 3. In addition, the electrical signals converted by the active pixel sensor array 1 may be provided to the correlated double sampler 6.

The row driver 3 may provide the plurality of driving signals for driving the plurality of pixels to the active pixel sensor array 1 in response to signals decoded in the row decoder 2. When the pixels are arranged in a matrix form, the driving signals may be provided in the unit of row of the matrix form.

The timing generator 5 may provide timing signals and control signals to the row decoder 2 and the column decoder 4.

The correlated double sampler (CDS) 6 may receive electrical signals generated from the active pixel sensor array 1 and may hold and sample the received electrical signals. The correlated double sampler 6 may doubly sample a specific noise level and a signal level of the electrical signal and may output a difference level corresponding to a difference between the noise level and the signal level.

The analog-to-digital converter (ADC) 7 may convert an analog signal, which corresponds to the difference level outputted from the correlated double sampler 6, into a digital signal and may output the digital signal.

The I/O buffer 8 may latch the digital signals and may sequentially output the latched signals to an image signal processing unit (not shown) in response to signals decoded in the column decoder 4.

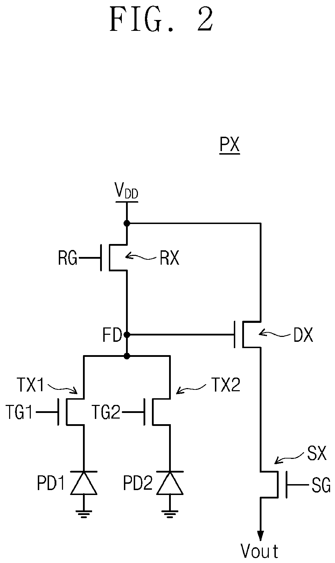

FIG. 2 is a circuit diagram illustrating a unit pixel of an image sensor according to some embodiments of the inventive concepts.

Referring to FIGS. 1 and 2, the active pixel sensor array 1 may include a plurality of pixels PX, and the pixels PX may be arranged in a matrix form. Each of the pixels PX may include a first photoelectric conversion element PD1, a second photoelectric conversion element PD2, a first transfer transistor TX1, a second transfer transistor TX2, and logic transistors RX, SX and DX. The logic transistors RX, SX and DX may include a reset transistor RX, a selection transistor SX, and a drive transistor DX. The first transfer transistor TX1, the second transfer transistor TX2, the reset transistor RX and the selection transistor SX may include a first transfer gate TG1, a second transfer gate TG2, a reset gate RG and a selection gate SG, respectively. Each of the pixels PX may further include a floating diffusion region FD.

The first and second photoelectric conversion elements PD1 and PD2 may generate and accumulate photocharges (or charges) in proportion to the amount of light incident from the outside. The first and second photoelectric conversion elements PD1 and PD2 may be photodiodes, each of which includes a P-type dopant region and an N-type dopant region. The first transfer transistor TX1 may transfer charges generated from the first photoelectric conversion element PD1 into the floating diffusion region FD, and the second transfer transistor TX2 may transfer charges generated from the second photoelectric conversion element PD2 into the floating diffusion region FD.

The floating diffusion region FD may receive charges generated from the first and second photoelectric conversion elements PD1 and PD2 and may cumulatively store the received charges. The drive transistor DX may be controlled according to the amount of charges accumulated in the floating diffusion region FD.

The reset transistor RX may periodically reset the charges accumulated in the floating diffusion region FD. A drain electrode of the reset transistor RX may be connected to the floating diffusion region FD, and a source electrode of the reset transistor RX may be connected to a power voltage V_{DD}. When the reset transistor RX is turned-on, the power voltage V_{DD} connected to the source electrode of the reset transistor RX may be applied to the floating diffusion region FD. Thus, when the reset transistor RX is turned-on, the charges accumulated in the floating diffusion region FD may be discharged to reset the floating diffusion region FD. It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element, there are no intervening elements present at the point of contact.

The drive transistor DX may function as a source follower buffer amplifier. The drive transistor DX may amplify a potential change in the floating diffusion region FD and may output the amplified potential change to an output line Vout.

The selection transistor SX may select the pixels PX to be read in the unit of row. When the selection transistor SX is turned-on, the power voltage V_{DD} may be applied to a drain electrode of the drive transistor DX.

The pixel PX including two photoelectric conversion elements PD 1 and PD2 and five transistors TX1, TX2, RX, DX and SX is illustrated as an example in FIG. 2, but embodiments of the inventive concepts are not limited thereto. In certain embodiments, the reset transistor RX, the drive transistor DX and/or the selection transistor SX may be shared by adjacent pixels PX. Thus, an integration density of the image sensor may be improved.

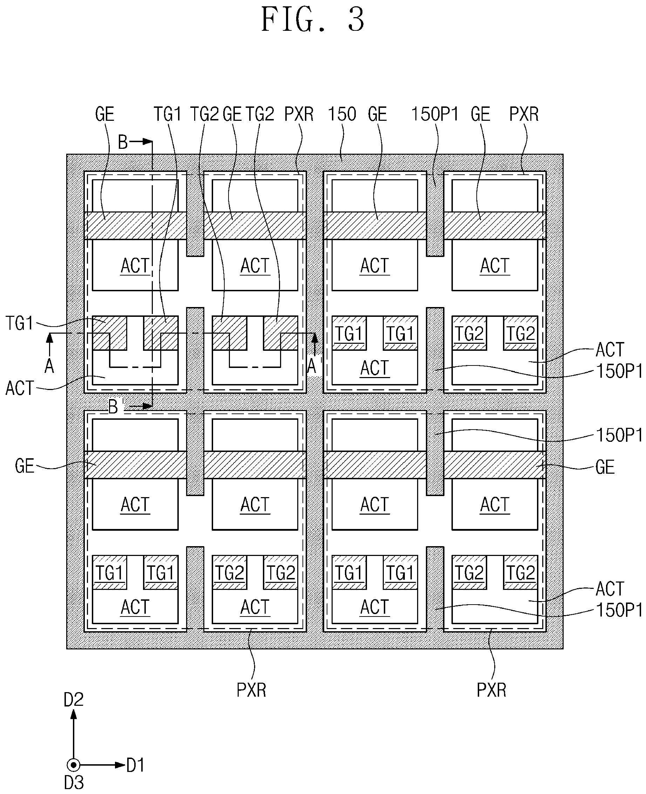

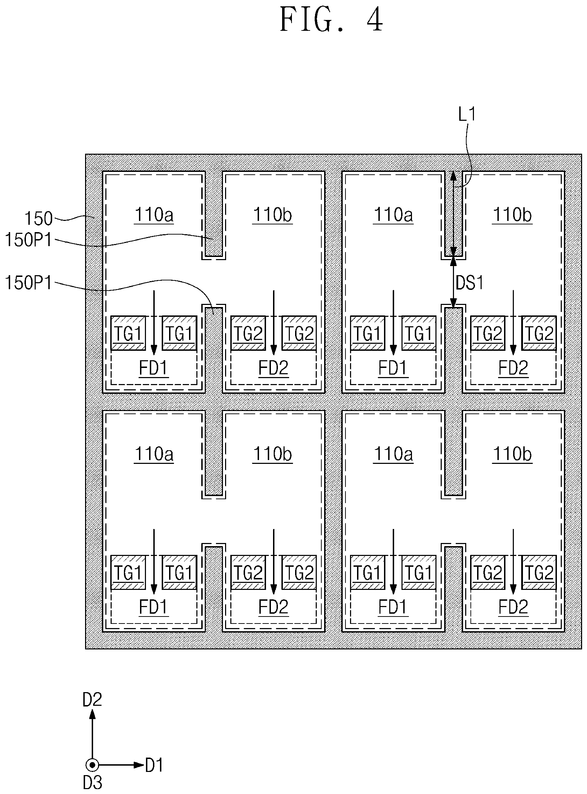

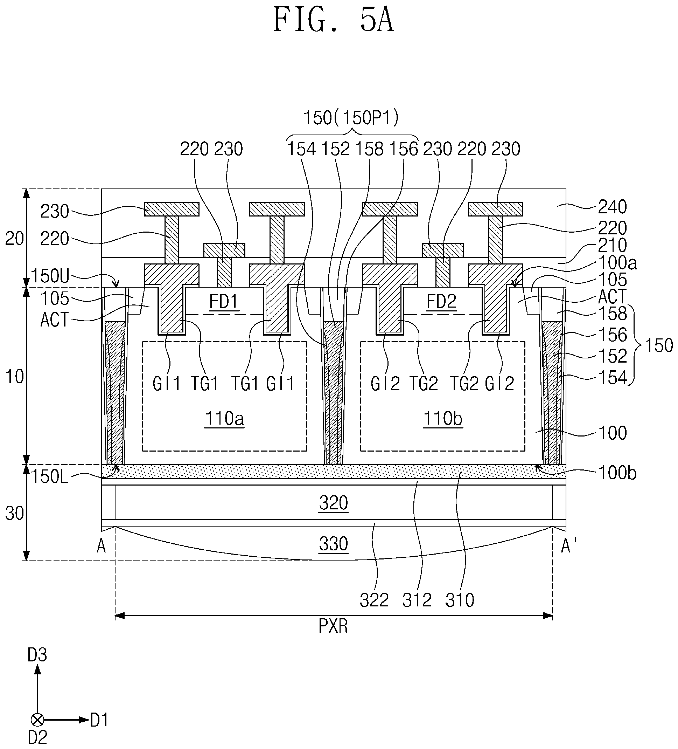

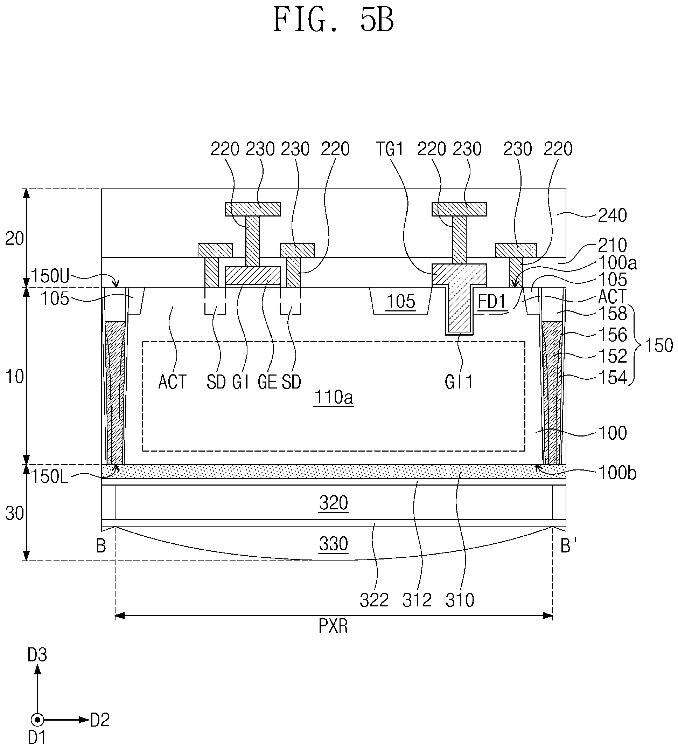

FIG. 3 is a plan view illustrating an image sensor according to some embodiments of the inventive concepts, and FIG. 4 is a plan view in which some components of FIG. 3 are omitted. FIGS. 5A and 5B are cross-sectional views taken along lines A-A' and B-B' of FIG. 3, respectively.

Referring to FIGS. 3, 4, 5A and 5B, an image sensor may include a photoelectric conversion layer 10, an interconnection layer 20, and a light transmitting layer 30. The light transmitting layer 30 may also be referred to as an optical conversion layer or an optical processing layer. The photoelectric conversion layer 10 may be disposed between the interconnection layer 20 and the light transmitting layer 30.

The photoelectric conversion layer 10 may include a substrate 100, and the substrate 100 may include a plurality of pixel regions PXR. The substrate 100 may be a semiconductor substrate (e.g., a silicon substrate, a germanium substrate, a silicon-germanium substrate, a group II-VI compound semiconductor substrate, or a group III-V compound semiconductor substrate) or a silicon-on-insulator (SOI) substrate. The substrate 100 may have a first surface 100a and a second surface 100b, which are opposite to each other. The plurality of pixel regions PXR may be two-dimensionally arranged in a first direction D1 and a second direction D2, which are parallel to the first surface 100a of the substrate 100. The first direction D1 and the second direction D2 may intersect each other.

The photoelectric conversion layer 10 may further include a deep device isolation pattern 150 which penetrates the substrate 100 and is disposed between the plurality of pixel regions PXR. The deep device isolation pattern 150 may penetrate the substrate 100 in a third direction D3 perpendicular to the first surface 100a of the substrate 100. The deep device isolation pattern 150 may extend from the first surface 100a of the substrate 100 toward the second surface 100b of the substrate 100. The first surface 100a of the substrate 100 may expose a top surface 150U of the deep device isolation pattern 150, and the second surface 100b of the substrate 100 may expose a bottom surface 150L of the deep device isolation pattern 150. The top surface 150U of the deep device isolation pattern 150 may be substantially coplanar with the first surface 100a of the substrate 100, and the bottom surface 150L of the deep device isolation pattern 150 may be substantially coplanar with the second surface 100b of the substrate 100. The deep device isolation pattern 150 may prevent cross-talk between the pixel regions PXR adjacent to each other. Terms such as "same," "equal," "planar," or "coplanar," as used herein encompass identicality or near identicality including variations that may occur, for example, due to manufacturing processes. The term "substantially" may be used herein to emphasize this meaning, unless the context or other statements indicate otherwise.

The deep device isolation pattern 150 may surround each of the plurality of pixel regions PXR when viewed in a plan view. The deep device isolation pattern 150 may extend in the first direction D1 and the second direction D2 to surround each of the pixel regions PXR. The deep device isolation pattern 150 may include first extensions 150P1 extending into each of the pixel regions PXR along the second direction D2. The first extensions 150P1 may be spaced apart from each other in the second direction D2 in each of the pixel regions PXR. A length L1, in the second direction D2, of each of the first extensions 150P1 may be greater than a distance DS1 in the second direction D2 between the first extensions 150P1. For example, the first extensions 150P1 may be spaced apart from each other in the second direction D2 in each of the pixel regions PXR by the distance DS1.

The deep device isolation pattern 150 may include a semiconductor pattern 152 and 154 penetrating at least a portion of the substrate 100, a filling insulation pattern 158 on the semiconductor pattern 152 and 154, and a side insulating pattern 156 disposed between the semiconductor pattern 152 and 154 and the substrate 100. The side insulating pattern 156 may extend from a side surface of the semiconductor pattern 152 and 154 onto a side surface of the filling insulation pattern 158. The semiconductor pattern 152 and 154 may include a first semiconductor pattern 152 penetrating at least a portion of the substrate 100, and a second semiconductor pattern 154 between the first semiconductor pattern 152 and the side insulating pattern 156. The first semiconductor pattern 152 may cover a topmost surface of the second semiconductor pattern 154 and may be in contact with the side insulating pattern 156. The filling insulation pattern 158 may be disposed on the first semiconductor pattern 152. The first semiconductor pattern 152 may extend between the filling insulation pattern 158 and the second semiconductor pattern 154 and may be in contact with the side insulating pattern 156.

Each of the first semiconductor pattern 152 and the second semiconductor pattern 154 may include a semiconductor material doped with dopants. The dopants may have a P-type or an N-type. For example, each of the first semiconductor pattern 152 and the second semiconductor pattern 154 may include poly-silicon doped with boron. For example, each of the side insulating pattern 156 and the filling insulation pattern 158 may include or may be formed of silicon oxide, silicon nitride, and/or silicon oxynitride.

A first photoelectric conversion region 110a and a second photoelectric conversion region 110b may be disposed in each of the pixel regions PXR and may be adjacent to each other in the first direction D1 in each of the pixel regions PXR. The first extensions 150P1 of the deep device isolation pattern 150 may be disposed between the first photoelectric conversion region 110a and the second photoelectric conversion region 110b. The first extensions 150P1 may extend in the second direction D2 between the first photoelectric conversion region 110a and the second photoelectric conversion region 110b and may be spaced apart from each other in the second direction D2. The first photoelectric conversion region 110a may extend in the second direction D2 at one side of the first extensions 150P1, and the second photoelectric conversion region 110b may extend in the second direction D2 at another side of the first extensions 150P1. For example, the first photoelectric conversion region 110a may continuously extend in the second direction D2 from one side of one of the first extensions 150P1 to one side of another of the first extensions 150P1, and the second photoelectric conversion region 110b may continuously extend in the second direction D2 from another side of the one of the first extensions 150P1 to another side of the other of the first extensions 150P1.

The substrate 100 may have a first conductivity type, and the first and second photoelectric conversion regions 110a and 110b may be regions doped with dopants having a second conductivity type different from the first conductivity type. For example, the first conductivity type and the second conductivity type may be a P-type and an N-type, respectively. In this case, the dopants having the second conductivity type may include N-type dopants such as phosphorus, arsenic, bismuth, and/or antimony. Each of the first and second photoelectric conversion regions 110a and 110b may form a PN junction with the substrate 100 to constitute a photodiode. For example, the first photoelectric conversion region 110a may form the PN junction with the substrate 100 to constitute the first photodiode (PD1 of FIG. 2), and the second photoelectric conversion region 110b may form the PN junction with the substrate 100 to constitute the second photodiode (PD2 of FIG. 2). Each of the pixel regions PXR may correspond to the unit pixel (PX of FIG. 2) including the first photodiode (PD1 of FIG. 2) and the second photodiode (PD2 of FIG. 2). In some embodiments, the semiconductor pattern 152 and 154 of the deep device isolation pattern 150 may include a semiconductor material doped with dopants having the first conductivity type (e.g., P-type dopants).

A shallow device isolation pattern 105 may be disposed adjacent to the first surface 100a of the substrate 100. Each of the plurality of pixel regions PXR may include active patterns ACT defined by the shallow device isolation pattern 105. For example, the shallow device isolation pattern 105 may include or may be formed of at least one of a silicon oxide layer, a silicon nitride layer, or a silicon oxynitride layer. The active patterns ACT may be spaced apart from each other in each of the pixel regions PXR, and the shallow device isolation pattern 105 may be disposed between the active patterns ACT. The deep device isolation pattern 150 may penetrate the shallow device isolation pattern 105 and may extend into the substrate 100. Each of the first extensions 150P1 of the deep device isolation pattern 150 may penetrate the shallow device isolation pattern 105 and may extend into each of the pixel regions PXR. A first set of the active patterns ACT may vertically overlap with the first photoelectric conversion region 110a (e.g., in the third direction D3), and a second set of the active patterns ACT may vertically overlap with the second photoelectric conversion region 110b (e.g., in the third direction D3). Each of the first extensions 150P1 may extend between corresponding active patterns ACT of the active patterns ACT.

The filling insulation pattern 158 of the deep device isolation pattern 150 may be disposed in the shallow device isolation pattern 105. The filling insulation pattern 158 may penetrate the shallow device isolation pattern 105 and may be in contact with the semiconductor pattern 152 and 154. For example, the filling insulation pattern 158 may penetrate the shallow device isolation pattern 105 and may contact the first semiconductor pattern 152. The side insulating pattern 156 of the deep device isolation pattern 150 may extend between the shallow device isolation pattern 105 and the filling insulation pattern 158.

A plurality of first transfer gate electrodes TG1, a first floating diffusion region FD1, a plurality of second transfer gate electrodes TG2 and a second floating diffusion region FD2 may be disposed on each of the pixel regions PXR and may be disposed adjacent to the first surface 100a of the substrate 100. The first transfer gate electrodes TG1 and the first floating diffusion region FD1 may be disposed on a corresponding active pattern ACT of the active patterns ACT and may vertically overlap with the first photoelectric conversion region 110a (e.g., in the third direction D3). The first photoelectric conversion region 110a may continuously extend in the second direction D2 under the first transfer gate electrodes TG1 and the first floating diffusion region FD1. The second transfer gate electrodes TG2 and the second floating diffusion region FD2 may be disposed on a corresponding active pattern ACT of the active patterns ACT and may vertically overlap with the second photoelectric conversion region 110b (e.g., in the third direction D3). The second photoelectric conversion region 110b may continuously extend in the second direction D2 under the second transfer gate electrodes TG2 and the second floating diffusion region FD2. Spatially relative terms, such as "under," "below," "lower," "above," "upper" and the like, may be used herein for ease of description to describe positional relationships, such as illustrated in the figures, e.g. It will be understood that the spatially relative terms encompass different orientations of the device in addition to the orientation depicted in the figures.

The first floating diffusion region FD1 and the second floating diffusion region FD2 may be spaced apart from each other in the first direction D1 with one of the first extensions 150P1 of the deep device isolation pattern 150 interposed therebetween. The first transfer gate electrodes TG1 may be disposed adjacent to the first floating diffusion region FD1, and the second transfer gate electrodes TG2 may be disposed adjacent to the second floating diffusion region FD2. In some embodiments, the second transfer gate electrodes TG2 may be spaced apart from the first transfer gate electrodes TG1 in the first direction D1 with the one of the first extensions 150P1 interposed therebetween.

A lower portion of each of the first transfer gate electrodes TG1 may extend into the substrate 100 (e.g., in the third direction D3) toward the first photoelectric conversion region 110a, and an upper portion of each of the first transfer gate electrodes TG1 may protrude above a top surface of the corresponding active pattern ACT (i.e., the first surface 100a of the substrate 100). A lower portion of each of the second transfer gate electrodes TG2 may extend into the substrate 100 (e.g., in the third direction D3) toward the second photoelectric conversion region 110b, and an upper portion of each of the second transfer gate electrodes TG2 may protrude above a top surface of the corresponding active pattern ACT (i.e., the first surface 100a of the substrate 100). The first floating diffusion region FD1 and the second floating diffusion region FD2 may be regions doped with dopants (e.g., N-type dopants) having the second conductivity type different from the first conductivity type of the substrate 100.

The first transfer gate electrodes TG1 and the first floating diffusion region FD 1 may constitute the first transfer transistor TX1 of FIG. 2. The second transfer gate electrodes TG2 and the second floating diffusion region FD2 may constitute the second transfer transistor TX2 of FIG. 2.

A first gate dielectric pattern GI1 may be disposed between each of the first transfer gate electrodes TG1 and the substrate 100 (i.e., the corresponding active pattern ACT), and a second gate dielectric pattern GI2 may be disposed between each of the second transfer gate electrodes TG2 and the substrate 100 (i.e., the corresponding active pattern ACT).

A plurality of gate electrodes GE and source/drain regions SD may be disposed on each of the pixel regions PXR and may be disposed adjacent to the first surface 100a of the substrate 100. The gate electrodes GE and the source/drain regions SD may be disposed on corresponding active patterns ACT of the active patterns ACT and may vertically overlap with the first photoelectric conversion region 110a or the second photoelectric conversion region 110b (e.g., in the third direction D3). For example, the source/drain regions SD may be regions doped with dopants (e.g., N-type dopants) having the second conductivity type different from the first conductivity type of the substrate 100. The gate electrodes GE and the source/drain regions SD may constitute the drive transistor DX, the selection transistor SX and the reset transistor RX of FIG. 2. A gate dielectric pattern GI may be disposed between each of the gate electrodes GE and the substrate 100 (i.e., the corresponding active pattern ACT).

The interconnection layer 20 may be disposed on the first surface 100a of the substrate 100. The interconnection layer 20 may include a first interlayer insulating layer 210 and a second interlayer insulating layer 240, which are sequentially stacked on the first surface 100a of the substrate 100. The first interlayer insulating layer 210 may be disposed on the first surface 100a of the substrate 100 to cover the first and second transfer gate electrodes TG1 and TG2 and the gate electrodes GE. The interconnection layer 20 may further include contact plugs 220 connected to the first and second transfer gate electrodes TG1 and TG2, the gate electrodes GE, the first and second floating diffusion regions FD1 and FD2 and the source/drain regions SD, and conductive lines 230 connected to the contact plugs 220. The contact plugs 220 may penetrate the first interlayer insulating layer 210 so as to be connected to the first and second transfer gate electrodes TG1 and TG2, the gate electrodes GE, the first and second floating diffusion regions FD1 and FD2, and the source/drain regions SD. The conductive lines 230 may be disposed in the second interlayer insulating layer 240. At least some of the contact plugs 220 may extend into the second interlayer insulating layer 240 so as to be connected to the conductive lines 230. The first interlayer insulating layer 210 and the second interlayer insulating layer 240 may include an insulating material, and the contact plugs 220 and the conductive lines 230 may include a conductive material.

The light transmitting layer 30 may be disposed on the second surface 100b of the substrate 100. The light transmitting layer 30 may include a color filter array 320 and a micro lens array 330, which are disposed on the second surface 100b of the substrate 100. The color filter array 320 may be disposed between the second surface 100b of the substrate 100 and the micro lens array 330. The light transmitting layer 30 may concentrate and filter light incident from the outside and may provide the light to the photoelectric conversion layer 10.

The color filter array 320 may include a plurality of color filters 320 disposed on the plurality of pixel regions PXR, respectively. Each of the color filters 320 may be disposed on each of the pixel regions PXR and may vertically overlap with the first and second photoelectric conversion regions 110a and 110b of each of the pixel regions PXR (e.g., in the third direction D3). The micro lens array 330 may include a plurality of micro lenses 330 disposed on the plurality of color filters 320, respectively. Each of the micro lenses 330 may be disposed on each of the pixel regions PXR and may vertically overlap with the first and second photoelectric conversion regions 110a and 110b of each of the pixel regions PXR (e.g., in the third direction D3).

An anti-reflection layer 310 may be disposed between the second surface 100b of the substrate 100 and the color filter array 320. The anti-reflection layer 310 may prevent reflection of light incident to the second surface 100b of the substrate 100 to allow the light to smoothly reach the first and second photoelectric conversion regions 110a and 110b. A first insulating layer 312 may be disposed between the anti-reflection layer 310 and the color filter array 320, and a second insulating layer 322 may be disposed between the color filter array 320 and the micro lens array 330.

According to embodiments of the inventive concepts, each of the pixel regions PXR may include the first photoelectric conversion region 110a and the second photoelectric conversion region 110b which are adjacent to each other in the first direction D1, and the deep device isolation pattern 150 may include the first extensions 150P1 disposed between the first photoelectric conversion region 110a and the second photoelectric conversion region 110b. In this case, each of the pixel regions PXR may include two photodiodes formed by the first photoelectric conversion region 110a and the second photoelectric conversion region 110b, and thus a charge storage capacity (or full well capacity) of each of the pixel regions PXR may be increased. In addition, the plurality of first transfer gate electrodes TG1 may be disposed on the first photoelectric conversion region 110a to electrically connect the first photoelectric conversion region 110a to the first floating diffusion region FD1, and the plurality of second transfer gate electrodes TG2 may be disposed on the second photoelectric conversion region 110b to electrically connect the second photoelectric conversion region 110b to the second floating diffusion region FD2. Since at least two first transfer gate electrodes TG1 are disposed on the first photoelectric conversion region 110a and at least two second transfer gate electrodes TG2 are disposed on the second photoelectric conversion region 110b, charge transfer characteristics of each of the pixel regions PXR may be improved.

As a result, it is possible to provide the image sensor capable of improving the charge transfer characteristics and the charge storage capacity (or full well capacity) of the unit pixel.

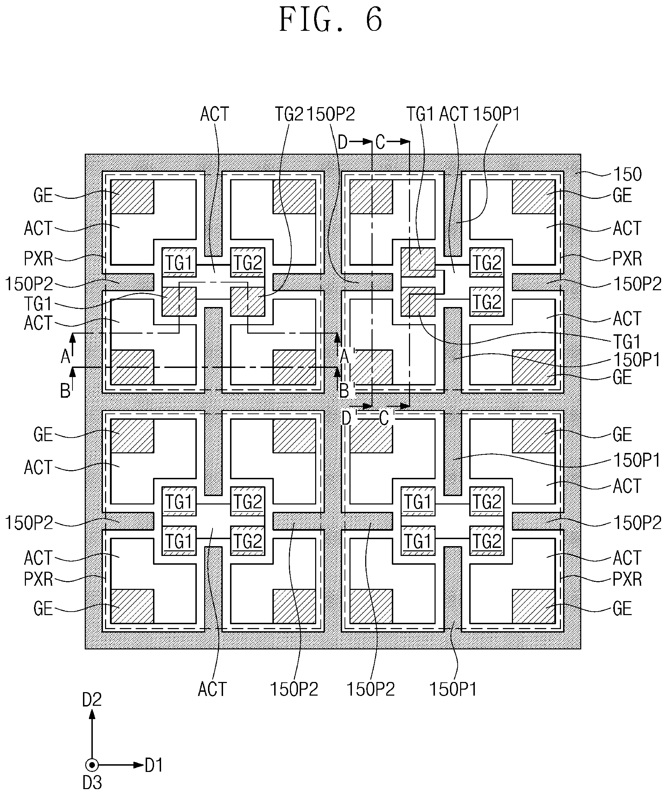

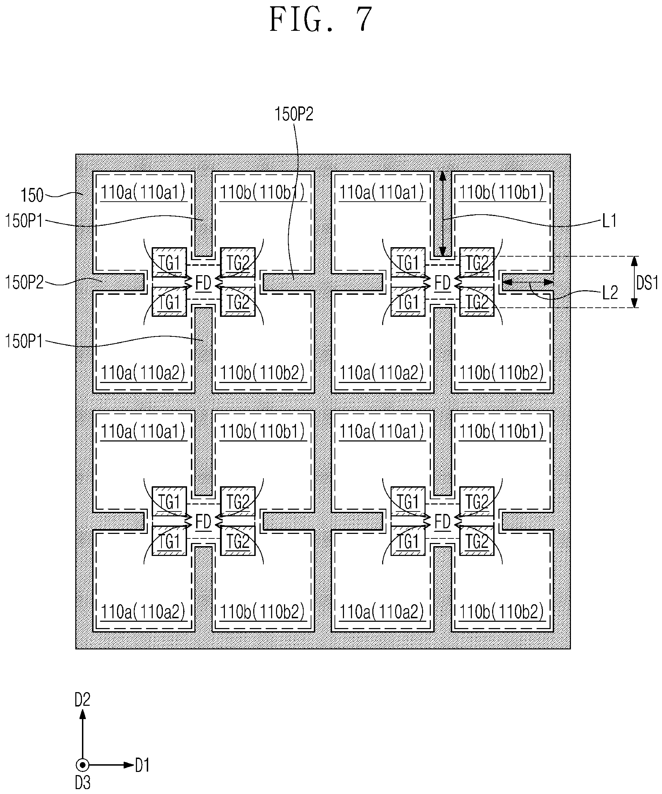

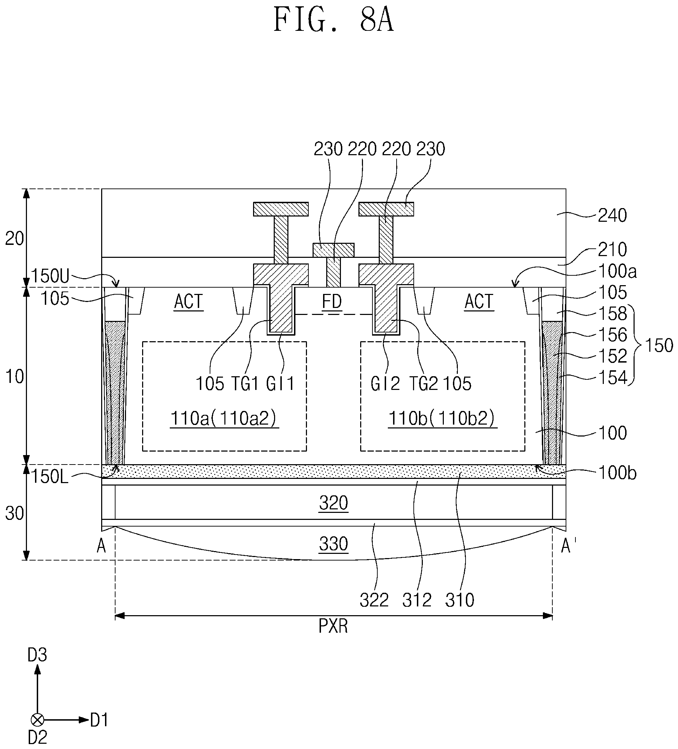

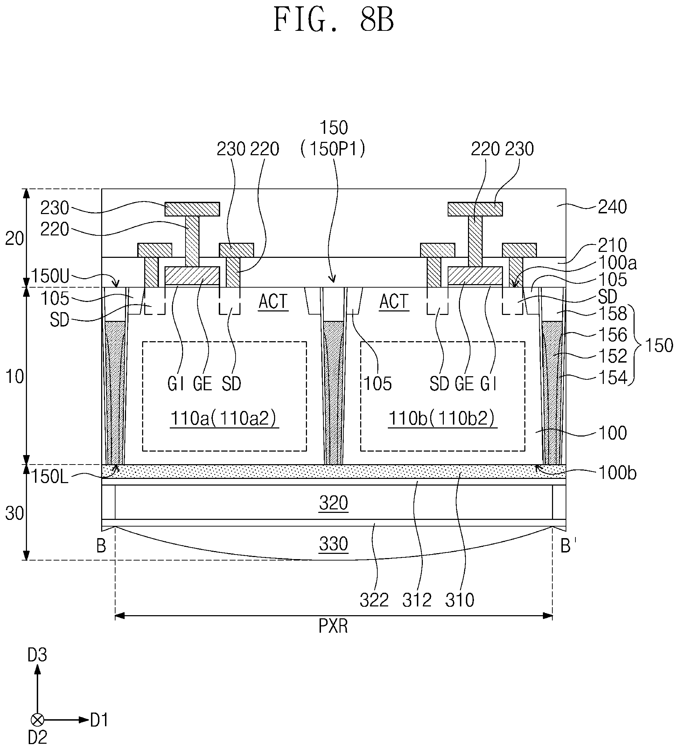

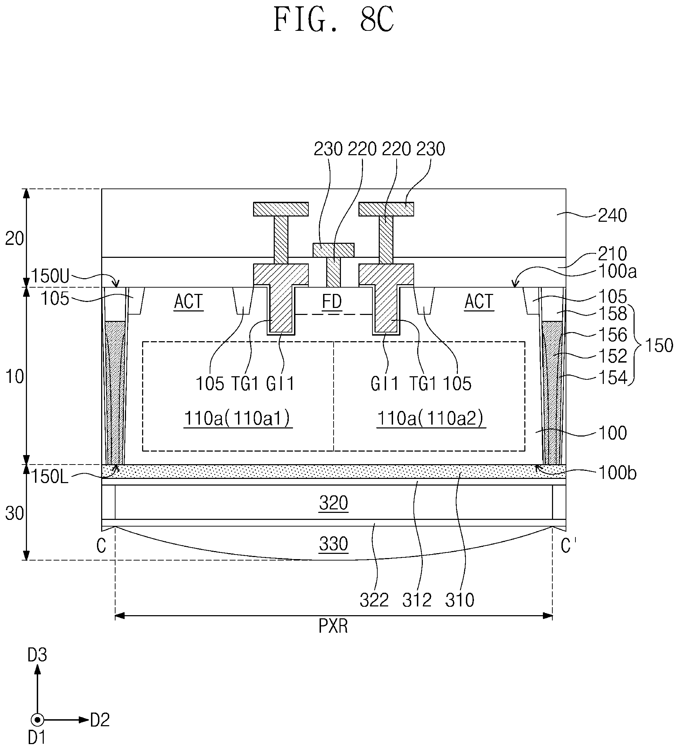

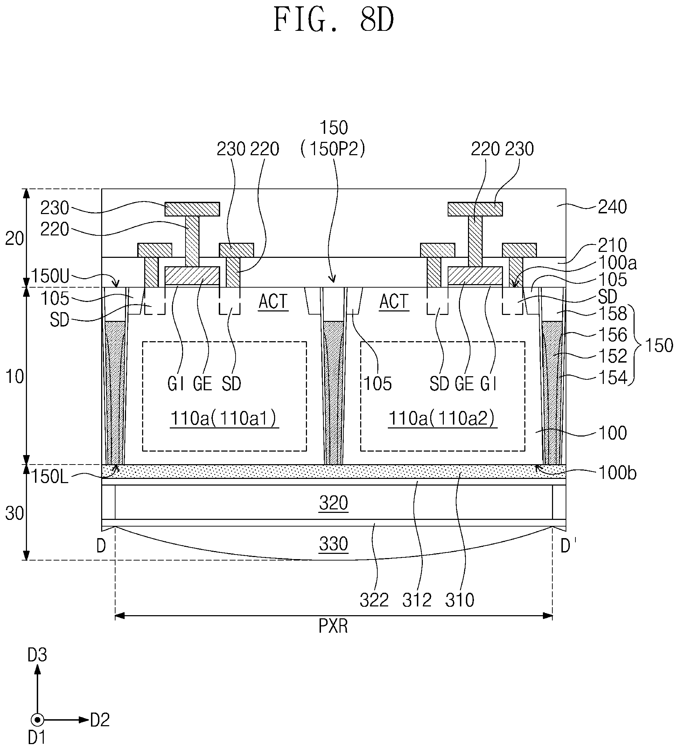

FIG. 6 is a plan view illustrating an image sensor according to some embodiments of the inventive concepts, and FIG. 7 is a plan view in which some components of FIG. 6 are omitted. FIGS. 8A, 8B, 8C and 8D are cross-sectional views taken along lines A-A', B-B', C-C' and D-D' of FIG. 6, respectively. Hereinafter, differences between the present embodiments and the above embodiments of FIGS. 3, 4, 5A and 5B will be mainly described for the purpose of ease and convenience in explanation.

Referring to FIGS. 6, 7 and 8A to 8D, the deep device isolation pattern 150 may further include second extensions 150P2 extending into each of the pixel regions PXR in the first direction D1. The second extensions 150P2 may be spaced apart from each other in the first direction D1 in each of the pixel regions PXR. A length L2, in the first direction D1, of each of the second extensions 150P2 may be equal to or less than the length L1, in the second direction D2, of each of the first extensions 150P1.

One of the second extensions 150P2 may extend into the first photoelectric conversion region 110a in the first direction D1, and another of the second extensions 150P2 may extend into the second photoelectric conversion region 110b in an opposite direction to the first direction D1. The one of the second extensions 150P2 may be disposed between a first portion 110a1 and a second portion 110a2 of the first photoelectric conversion region 110a, and the other of the second extensions 150P2 may be disposed between a third portion 110b1 and a fourth portion 110b2 of the second photoelectric conversion region 110b. The first photoelectric conversion region 110a may continuously extend in the second direction D2 between the second extensions 150P2. For example, the first portion 110a1 and the second portion 110a2 of the first photoelectric conversion region 110a may be continuously connected to each other between the second extensions 150P2. The second photoelectric conversion region 110b may continuously extend in the second direction D2 between the second extensions 150P2. For example, the third portion 110b1 and the fourth portion 110b2 of the second photoelectric conversion region 110b may be continuously connected to each other between the second extensions 150P2.

The active patterns ACT may be spaced apart from each other in each of the pixel regions PXR, and the shallow device isolation pattern 105 may be disposed between the active patterns ACT. The deep device isolation pattern 150 may penetrate the shallow device isolation pattern 105 and may extend into the substrate 100. Each of the first extensions 150P1 of the deep device isolation pattern 150 may penetrate the shallow device isolation pattern 105 and may extend into each of the pixel regions PXR, and each of the second extensions 150P2 of the deep device isolation pattern 150 may penetrate the shallow device isolation pattern 105 and may extend into each of the pixel regions PXR. At least one of the active patterns ACT may be disposed between the first extensions 150P1 and between the second extensions 150P2. The other active patterns ACT may vertically overlap with the first portion 110a1 and the second portion 110a2 of the first photoelectric conversion region 110a and the third portion 110b1 and the fourth portion 110b2 of the second photoelectric conversion region 110b (e.g., in the third direction D3), respectively.

A plurality of first transfer gate electrodes TG1, a floating diffusion region FD and a plurality of second transfer gate electrodes TG2 may be disposed on each of the pixel regions PXR and may be disposed adjacent to the first surface 100a of the substrate 100. The floating diffusion region FD may be disposed in a corresponding active pattern ACT between the first extensions 150P1 and between the second extensions 150P2. The first transfer gate electrodes TG1 and the second transfer gate electrodes TG2 may be disposed adjacent to the floating diffusion region FD and may be disposed on the corresponding active pattern ACT.

The first transfer gate electrodes TG1 may vertically overlap with the first photoelectric conversion region 110a (e.g., in the third direction D3). One of the first transfer gate electrodes TG1 may vertically overlap with the first portion 110a1 of the first photoelectric conversion region 110a (e.g., in the third direction D3) and may electrically connect the first portion 110a1 of the first photoelectric conversion region 110a to the floating diffusion region FD. Another of the first transfer gate electrodes TG1 may vertically overlap with the second portion 110a2 of the first photoelectric conversion region 110a (e.g., in the third direction D3) and may electrically connect the second portion 110a2 of the first photoelectric conversion region 110a to the floating diffusion region FD. The first transfer gate electrodes TG1 and the floating diffusion region FD may constitute the first transfer transistor TX1 of FIG. 2. The first portion 110a1 and the second portion 110a2 of the first photoelectric conversion region 110a may be continuously connected to each other in the second direction D2 under the first transfer gate electrodes TG1. For example, the first photoelectric conversion region 110a may continuously extend in the second direction D2 under the first transfer gate electrodes TG1.

The second transfer gate electrodes TG2 may vertically overlap with the second photoelectric conversion region 110b (e.g., in the third direction D3). One of the second transfer gate electrodes TG2 may vertically overlap with the third portion 110b1 of the second photoelectric conversion region 110b (e.g., in the third direction D3) and may electrically connect the third portion 110b1 of the second photoelectric conversion region 110b to the floating diffusion region FD. Another of the second transfer gate electrodes TG2 may vertically overlap with the fourth portion 110b2 of the second photoelectric conversion region 110b (e.g., in the third direction D3) and may electrically connect the fourth portion 110b2 of the second photoelectric conversion region 110b to the floating diffusion region FD. The second transfer gate electrodes TG2 and the floating diffusion region FD may constitute the second transfer transistor TX2 of FIG. 2. The third portion 110b1 and the fourth portion 110b2 of the second photoelectric conversion region 110b may be continuously connected to each other in the second direction D2 under the second transfer gate electrodes TG2. For example, the second photoelectric conversion region 110b may continuously extend in the second direction D2 under the second transfer gate electrodes TG2.

Except for the above differences, other components and/or features of the image sensor according to the present embodiments may be substantially the same as corresponding components and/or features of the image sensor described with reference to FIGS. 3, 4, 5A and 5B.

According to the present embodiments, each of the pixel regions PXR may include the first photoelectric conversion region 110a and the second photoelectric conversion region 110b which are adjacent to each other in the first direction D1, and the deep device isolation pattern 150 may include the first extensions 150P1 disposed between the first photoelectric conversion region 110a and the second photoelectric conversion region 110b, and the second extensions 150P2 extending into the first photoelectric conversion region 110a and the second photoelectric conversion region 110b, respectively. In this case, each of the pixel regions PXR may include four photodiodes formed by the first portion 110a1 and the second portion 110a2 of the first photoelectric conversion region 110a and the third portion 110b1 and the fourth portion 110b2 of the second photoelectric conversion region 110b, and thus a charge storage capacity (or full well capacity) of each of the pixel regions PXR may be increased. In addition, the plurality of first transfer gate electrodes TG1 may be disposed on the first photoelectric conversion region 110a to electrically connect the first photoelectric conversion region 110a to the floating diffusion region FD, and the plurality of second transfer gate electrodes TG2 may be disposed on the second photoelectric conversion region 110b to electrically connect the second photoelectric conversion region 110b to the floating diffusion region FD. Since at least two first transfer gate electrodes TG1 are disposed on the first photoelectric conversion region 110a and at least two second transfer gate electrodes TG2 are disposed on the second photoelectric conversion region 110b, charge transfer characteristics of each of the pixel regions PXR may be improved.

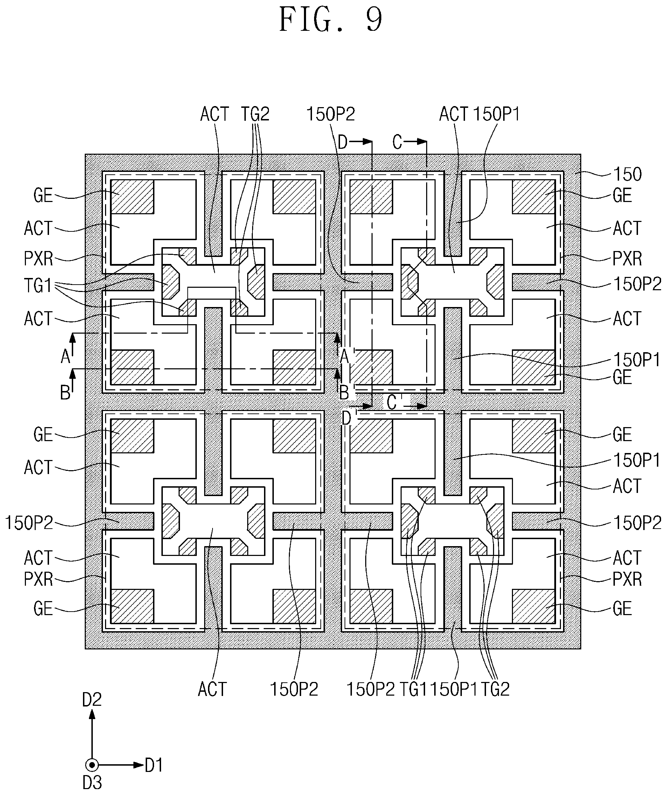

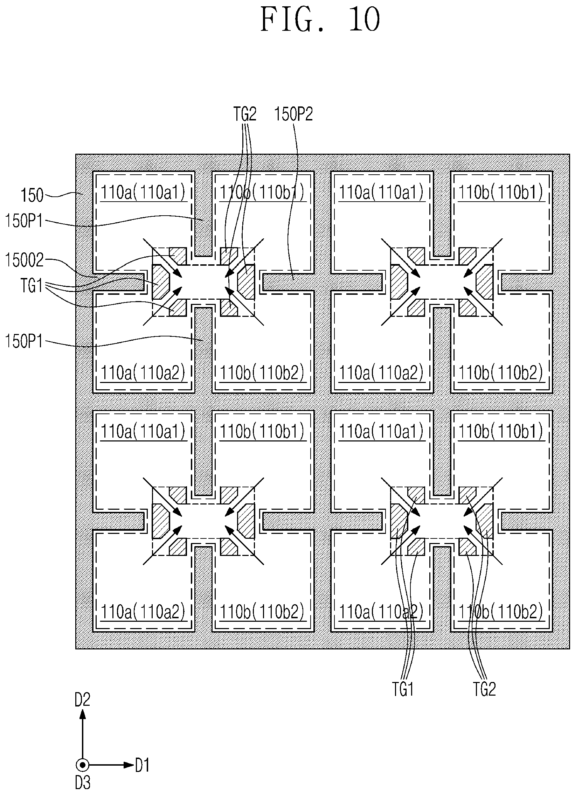

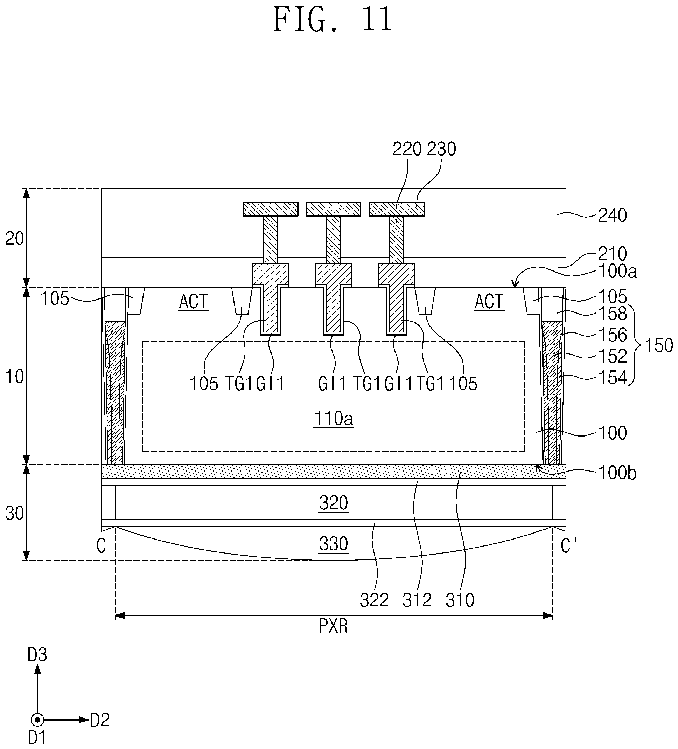

FIG. 9 is a plan view illustrating an image sensor according to some embodiments of the inventive concepts, and FIG. 10 is a plan view in which some components of FIG. 9 are omitted. FIG. 11 is a cross-sectional view taken along a line C-C' of FIG. 9. Cross-sectional views taken along lines A-A', B-B' and D-D' of FIG. 9 are substantially the same as FIGS. 8A, 8B and 8D, respectively. Hereinafter, differences between the present embodiments and the above embodiments of FIGS. 6, 7 and 8A to 8D will be mainly described for the purpose of ease and convenience in explanation.

Referring to FIGS. 9, 10 and 11, the first transfer gate electrodes TG1 may vertically overlap with the first photoelectric conversion region 110a (e.g., in the third direction D3). Each of the first transfer gate electrodes TG1 may electrically connect the first photoelectric conversion region 110a to the floating diffusion region FD. In some embodiments, three first transfer gate electrodes TG1 may be disposed on the first photoelectric conversion region 110a and may electrically connect the first photoelectric conversion region 110a to the floating diffusion region FD. The first transfer gate electrodes TG1 and the floating diffusion region FD may constitute the first transfer transistor TX1 of FIG. 2. The first photoelectric conversion region 110a may continuously extend in the second direction D2 under the first transfer gate electrodes TG1.

The second transfer gate electrodes TG2 may vertically overlap with the second photoelectric conversion region 110b (e.g., in the third direction D3). Each of the second transfer gate electrodes TG2 may electrically connect the second photoelectric conversion region 110b to the floating diffusion region FD. In some embodiments, three second transfer gate electrodes TG2 may be disposed on the second photoelectric conversion region 110b and may electrically connect the second photoelectric conversion region 110b to the floating diffusion region FD. The second transfer gate electrodes TG2 and the floating diffusion region FD may constitute the second transfer transistor TX2 of FIG. 2. The second photoelectric conversion region 110b may continuously extend in the second direction D2 under the second transfer gate electrodes TG2.

Except for the above differences, other components and/or features of the image sensor according to the present embodiments may be substantially the same as corresponding components and/or features of the image sensor described with reference to FIGS. 6, 7 and 8A to 8D.

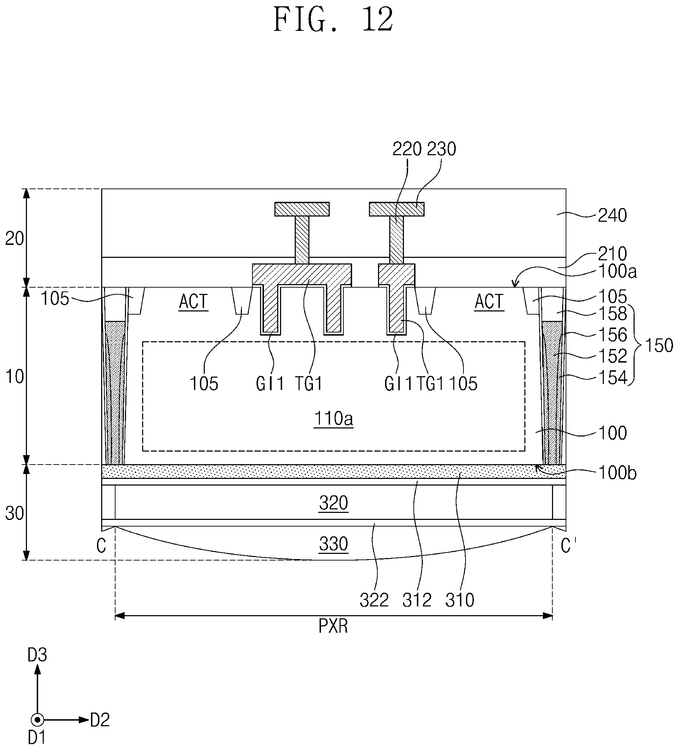

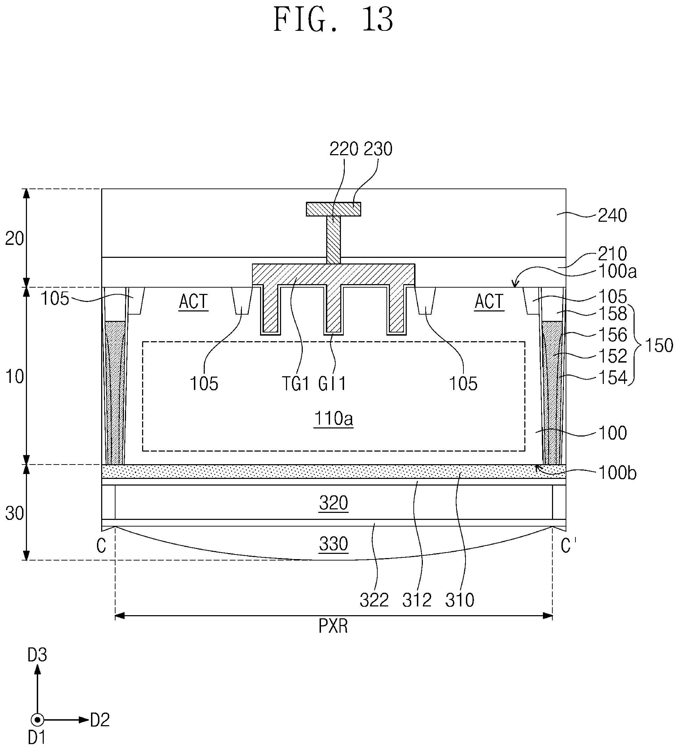

FIGS. 12 and 13 are cross-sectional views corresponding to the line C-C' of FIG. 9 to illustrate image sensors according to some embodiments of the inventive concepts.

Referring to FIGS. 9, 12 and 13, a lower portion of each of the first transfer gate electrodes TG1 may extend into the substrate 100 toward the first photoelectric conversion region 110a, and an upper portion of each of the first transfer gate electrodes TG1 may protrude above a top surface of a corresponding active pattern ACT (i.e., the first surface 100a of the substrate 100). In some embodiments, the upper portions of adjacent first transfer gate electrodes TG1 of the first transfer gate electrodes TG1 may be connected to each other. For example, as illustrated in FIG. 12, the upper portion of one of the first transfer gate electrodes TG1 may be spaced apart from the upper portions of the other first transfer gate electrodes TG1, and the upper portions of the other first transfer gate electrodes TG1 may be connected to each other. In certain embodiments, as illustrated in FIG. 13, the upper portions of all of the first transfer gate electrodes TG1 may be connected to each other.

A lower portion of each of the second transfer gate electrodes TG2 may extend into the substrate 100 toward the second photoelectric conversion region 110b, and an upper portion of each of the second transfer gate electrodes TG2 may protrude above a top surface of a corresponding active pattern ACT (i.e., the first surface 100a of the substrate 100). In some embodiments, the upper portions of adjacent second transfer gate electrodes TG2 of the second transfer gate electrodes TG2 may be connected to each other. For example, similarly to FIG. 12, the upper portion of one of the second transfer gate electrodes TG2 may be spaced apart from the upper portions of the other second transfer gate electrodes TG2, and the upper portions of the other second transfer gate electrodes TG2 may be connected to each other. In certain embodiments, similarly to FIG. 13, the upper portions of all of the second transfer gate electrodes TG2 may be connected to each other.

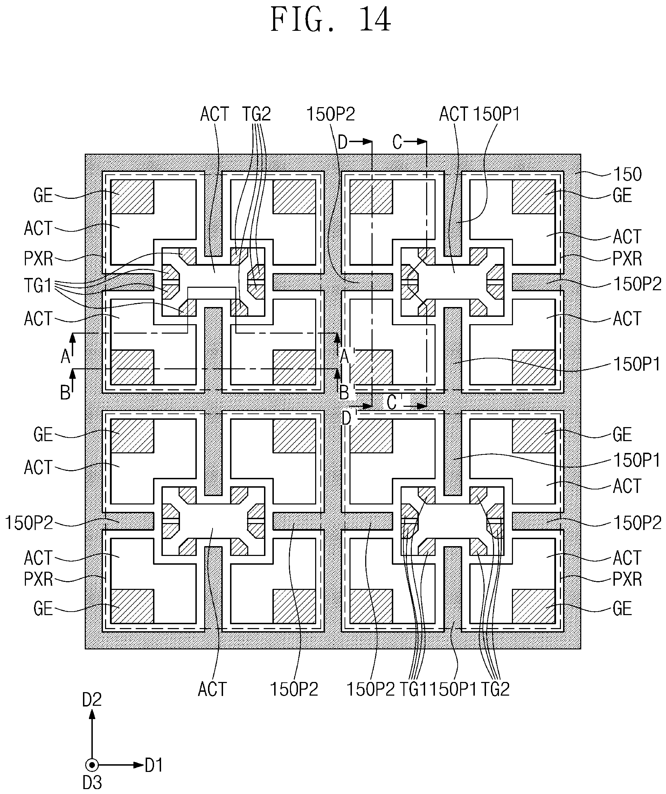

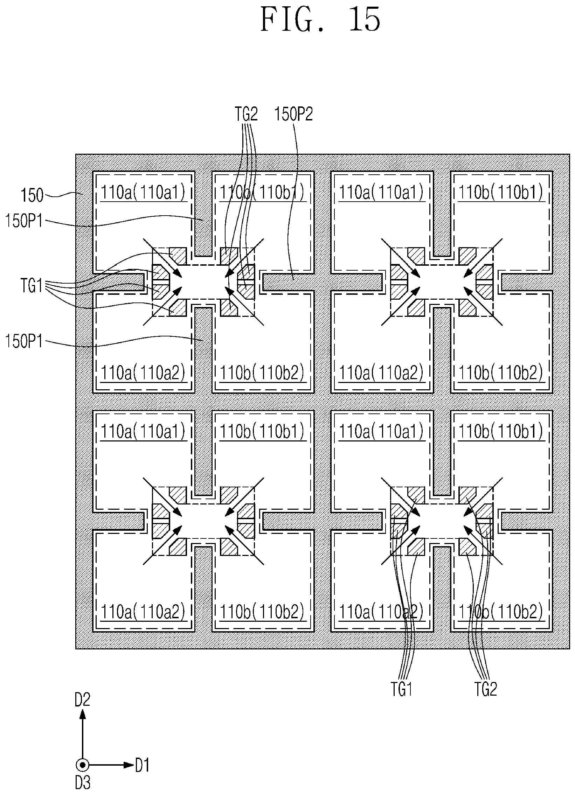

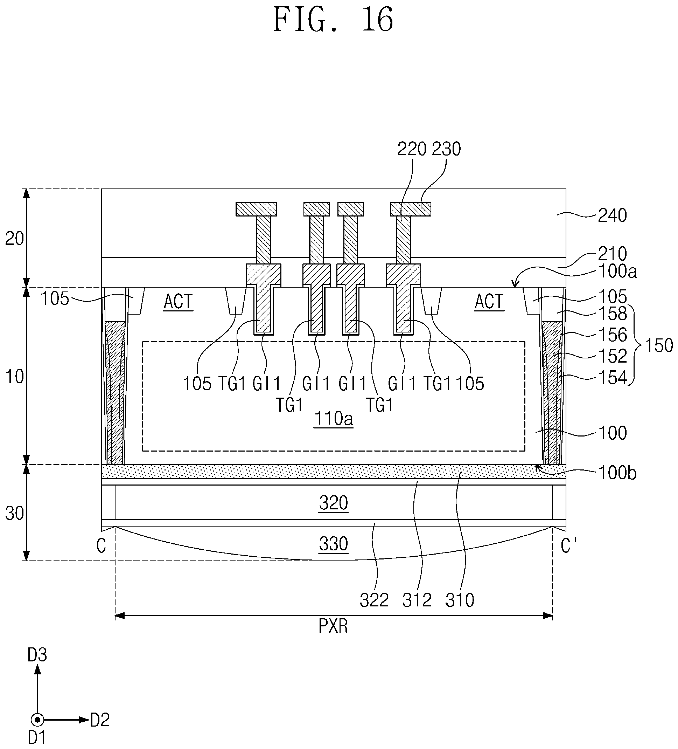

FIG. 14 is a plan view illustrating an image sensor according to some embodiments of the inventive concepts, and FIG. 15 is a plan view in which some components of FIG. 14 are omitted. FIG. 16 is a cross-sectional view taken along a line C-C' of FIG. 14. Cross-sectional views taken along lines A-A', B-B' and D-D' of FIG. 14 are substantially the same as FIGS. 8A, 8B and 8D, respectively. Hereinafter, differences between the present embodiments and the above embodiments of FIGS. 6, 7 and 8A to 8D will be mainly described for the purpose of ease and convenience in explanation.

Referring to FIGS. 14, 15 and 16, the first transfer gate electrodes TG1 may vertically overlap with the first photoelectric conversion region 110a (e.g., in the third direction D3). Each of the first transfer gate electrodes TG1 may electrically connect the first photoelectric conversion region 110a to the floating diffusion region FD. In some embodiments, four first transfer gate electrodes TG1 may be disposed on the first photoelectric conversion region 110a and may electrically connect the first photoelectric conversion region 110a to the floating diffusion region FD. The first transfer gate electrodes TG1 and the floating diffusion region FD may constitute the first transfer transistor TX1 of FIG. 2. The first photoelectric conversion region 110a may continuously extend in the second direction D2 under the first transfer gate electrodes TG1.

The second transfer gate electrodes TG2 may vertically overlap with the second photoelectric conversion region 110b (e.g., in the third direction D3). Each of the second transfer gate electrodes TG2 may electrically connect the second photoelectric conversion region 110b to the floating diffusion region FD. In some embodiments, four second transfer gate electrodes TG2 may be disposed on the second photoelectric conversion region 110b and may electrically connect the second photoelectric conversion region 110b to the floating diffusion region FD. The second transfer gate electrodes TG2 and the floating diffusion region FD may constitute the second transfer transistor TX2 of FIG. 2. The second photoelectric conversion region 110b may continuously extend in the second direction D2 under the second transfer gate electrodes TG2.

Except for the above differences, other components and/or features of the image sensor according to the present embodiments may be substantially the same as corresponding components and/or features of the image sensor described with reference to FIGS. 6, 7 and 8A to 8D.

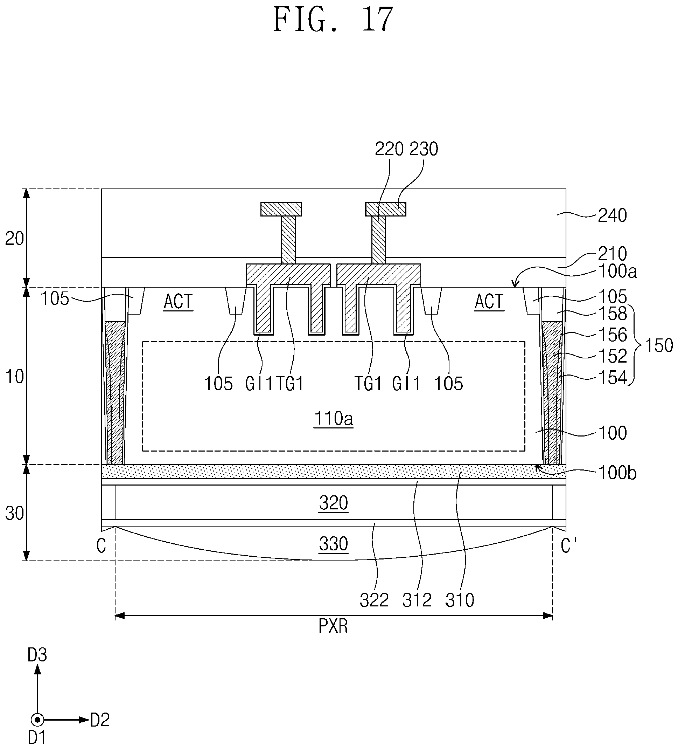

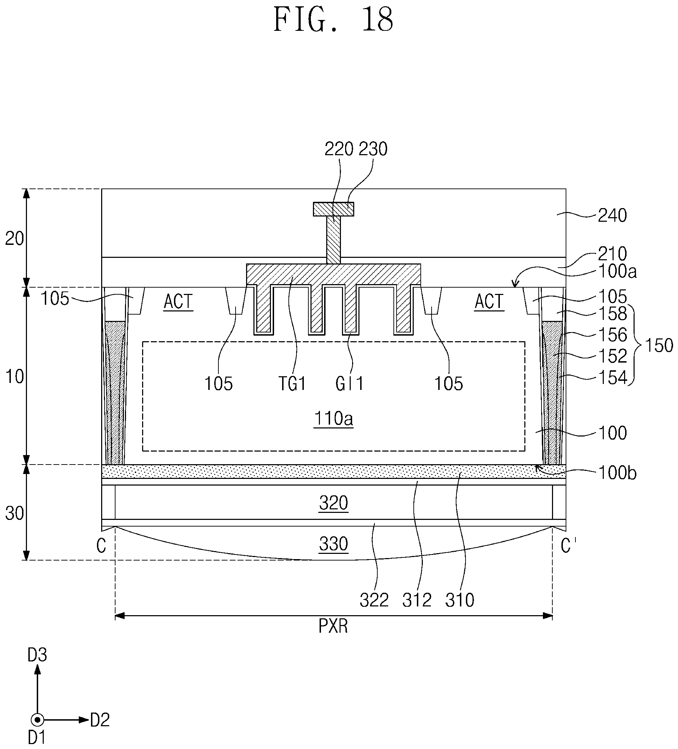

FIGS. 17 and 18 are cross-sectional views corresponding to the line C-C' of FIG. 14 to illustrate image sensors according to some embodiments of the inventive concepts.

Referring to FIGS. 14, 17 and 18, a lower portion of each of the first transfer gate electrodes TG1 may extend into the substrate 100 toward the first photoelectric conversion region 110a, and an upper portion of each of the first transfer gate electrodes TG1 may protrude above a top surface of a corresponding active pattern ACT (i.e., the first surface 100a of the substrate 100). In some embodiments, the upper portions of adjacent first transfer gate electrodes TG1 of the first transfer gate electrodes TG1 may be connected to each other. For example, as illustrated in FIG. 17, the upper portions of a pair of first transfer gate electrodes TG1 of the first transfer gate electrodes TG1 may be connected to each other, and the upper portions of another pair of first transfer gate electrodes TG1 of the first transfer gate electrodes TG1 may be connected to each other. The upper portions of the pair of first transfer gate electrodes TG1 may be spaced apart from the upper portions of the other pair of first transfer gate electrodes TG1. In certain embodiments, as illustrated in FIG. 18, the upper portions of all of the first transfer gate electrodes TG1 may be connected to each other.

A lower portion of each of the second transfer gate electrodes TG2 may extend into the substrate 100 toward the second photoelectric conversion region 110b, and an upper portion of each of the second transfer gate electrodes TG2 may protrude above a top surface of the corresponding active pattern ACT (i.e., the first surface 100a of the substrate 100). In some embodiments, the upper portions of adjacent second transfer gate electrodes TG2 of the second transfer gate electrodes TG2 may be connected to each other. For example, similarly to FIG. 17, the upper portions of a pair of second transfer gate electrodes TG2 of the second transfer gate electrodes TG2 may be connected to each other, and the upper portions of another pair of second transfer gate electrodes TG2 of the second transfer gate electrodes TG2 may be connected to each other. The upper portions of the pair of second transfer gate electrodes TG2 may be spaced apart from the upper portions of the other pair of second transfer gate electrodes TG2. In certain embodiments, similarly to FIG. 18, the upper portions of all of the second transfer gate electrodes TG2 may be connected to each other.

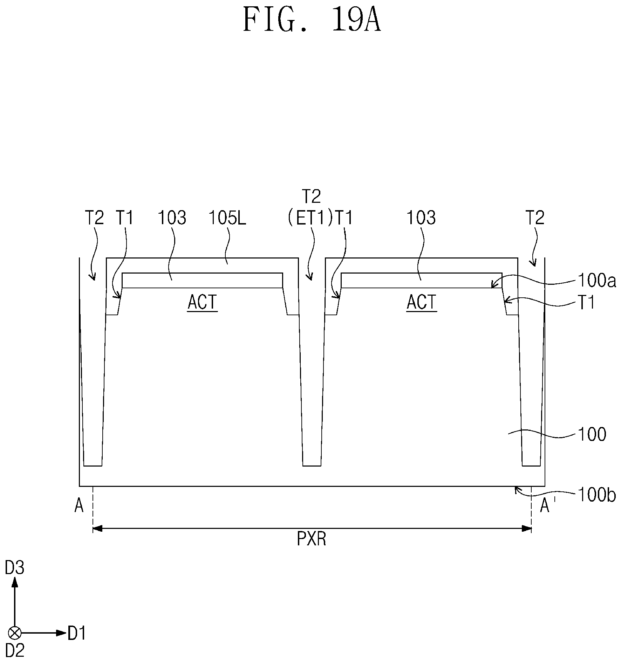

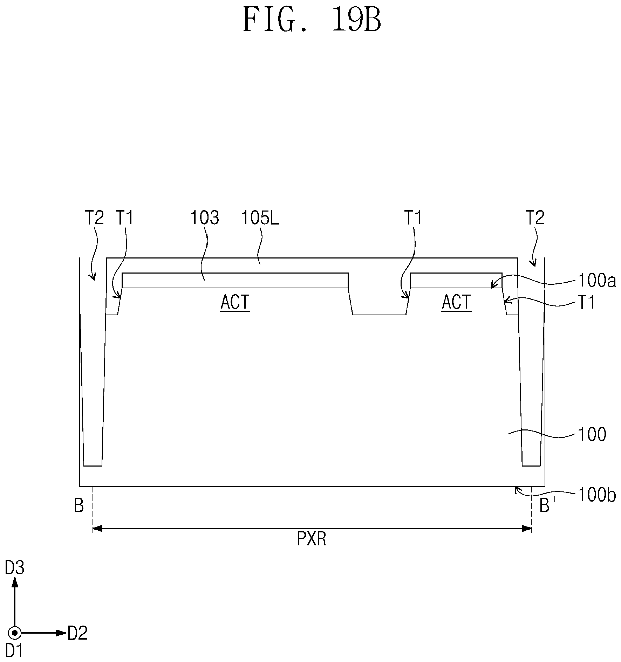

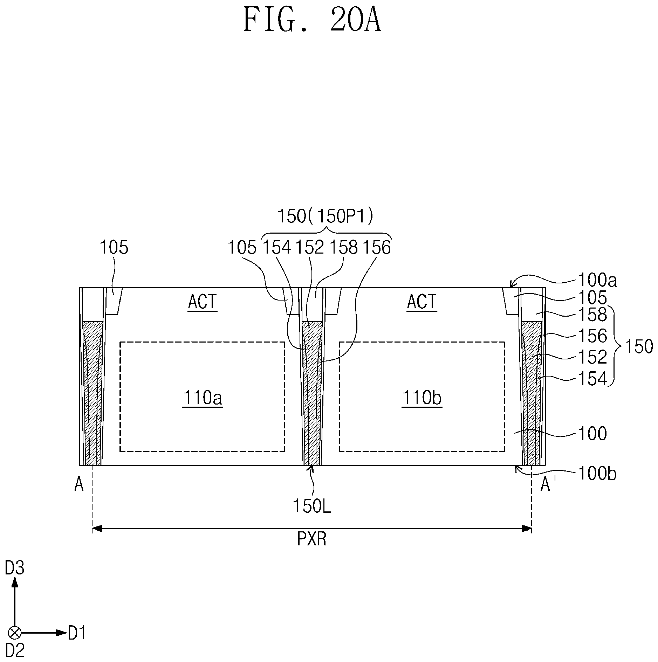

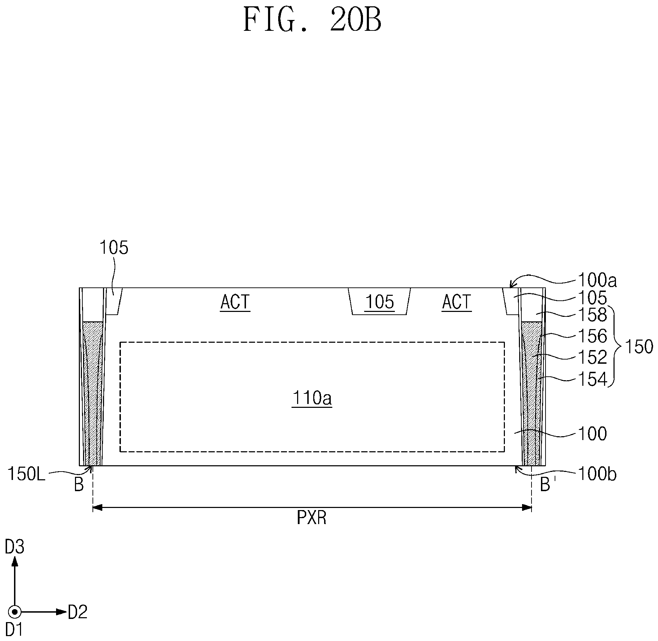

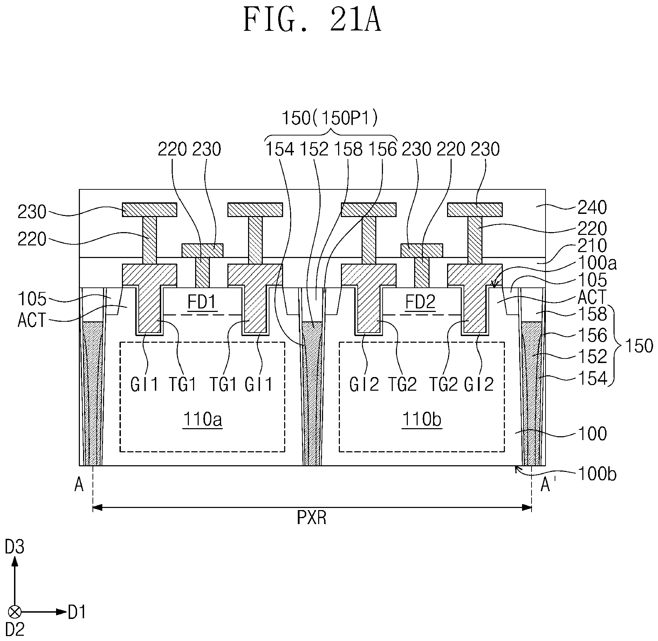

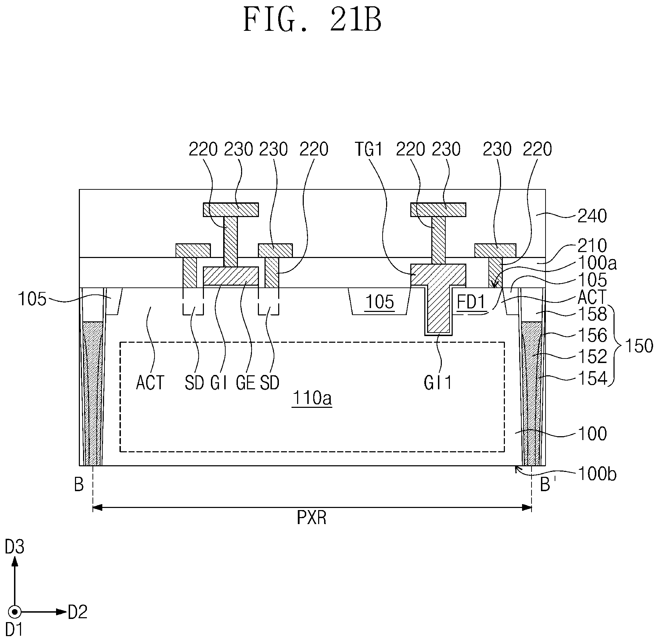

FIGS. 19A to 21A are cross-sectional views corresponding to the line A-A' of FIG. 3 to illustrate a method of manufacturing an image sensor according to some embodiments of the inventive concepts. FIGS. 19B to 21B are cross-sectional views corresponding to the line B-B' of FIG. 3 to illustrate a method of manufacturing an image sensor according to some embodiments of the inventive concepts. Hereinafter, the descriptions to the same features as mentioned with reference to FIGS. 3, 4, 5A and 5B will be omitted for the purpose of ease and convenience in explanation.

Referring to FIGS. 3, 4, 19A and 19B, a substrate 100 having first and second surfaces 100a and 100b opposite to each other may be provided. The substrate 100 may have a first conductivity type (e.g., a P-type). A first trench T1 may be formed adjacent to the first surface 100a of the substrate 100. The formation of the first trench T1 may include forming a first mask pattern 103 on the first surface 100a of the substrate 100, and etching the substrate 100 using the first mask pattern 103 as an etch mask. The first trench T1 may define active patterns ACT in the substrate 100.

A device isolation layer 105L may be formed on the first surface 100a of the substrate 100. The device isolation layer 105L may cover the first mask pattern 103 and may fill the first trench T1. For example, the device isolation layer 105L may include or may be formed of a silicon oxide layer, a silicon nitride layer, and/or a silicon oxynitride layer.

A second trench T2 may be formed in the substrate 100. The formation of the second trench T2 may include forming a second mask pattern (not shown) defining a region, in which the second trench T2 will be formed, on the device isolation layer 105L, and etching the device isolation layer 105L and the substrate 100 using the second mask pattern as an etch mask.

The second trench T2 may define a plurality of pixel regions PXR in the substrate 100. The plurality of pixel regions PXR may be arranged in the first direction D1 and the second direction D2. The second trench T2 may surround each of the pixel regions PXR when viewed in a plan view. The second trench T2 may extend in the first direction D1 and the second direction D2 to surround each of the pixel regions PXR. Each of the plurality of pixel regions PXR may include the active patterns ACT defined by the first trench T1. The second trench T2 may include first extension trenches ET1 extending into each of the pixel regions PXR. The first extension trenches ET1 may extend in the second direction D2 in each of the pixel regions PXR and may be spaced apart from each other in the second direction D2 in each of the pixel regions PXR. In some embodiments, as described with reference to FIG. 6, the second trench T2 may further include second extension trenches extending into each of the pixel regions PXR. The second extension trenches may extend in the first direction D1 in each of the pixel regions PXR and may be spaced apart from each other in the first direction D 1 in each of the pixel regions PXR.

Referring to FIGS. 3, 4, 20A and 20B, a deep device isolation pattern 150 may be formed to fill the second trench T2. The deep device isolation pattern 150 may include a side insulating pattern 156 conformally covering an inner surface of the second trench T2, a semiconductor pattern 152 and 154 filling a lower portion of the second trench T2, and a filling insulation pattern 158 filling a remaining portion of the second trench T2 on the semiconductor pattern 152 and 154. The semiconductor pattern 152 and 154 may include a first semiconductor pattern 152 filling a portion of the second trench T2, and a second semiconductor pattern 154 between the first semiconductor pattern 152 and the side insulating pattern 156. The deep device isolation pattern 150 may include first extensions 150P1 filling the first extension trenches ET1. In some embodiments, the deep device isolation pattern 150 may further include second extensions 150P2 filling the second extension trenches, as described with reference to FIG. 6.

For example, the formation of the deep device isolation pattern 150 may include forming a side insulating layer conformally covering the inner surface of the second trench T2 on the device isolation layer 105L, forming a second semiconductor layer filling a portion of the second trench T2 on the side insulating layer, anisotropically etching the second semiconductor layer to form the second semiconductor pattern 154, forming a first semiconductor layer filling the second trench T2 on the second semiconductor pattern 154, etching the first semiconductor layer by an etch-back process to form the first semiconductor pattern 152, forming a filling insulation layer filling a remaining portion of the second trench T2, and planarizing the filling insulation layer and the side insulating layer to form the filling insulation pattern 158 and the side insulating pattern 156. For example, the formation of the second semiconductor pattern 154 may further include injecting dopants having the first conductivity type (e.g., P-type dopants) into the second semiconductor pattern 154. The planarization process for forming the filling insulation pattern 158 and the side insulating pattern 156 may include planarizing the filling insulation layer, the side insulating layer and the device isolation layer 105L to expose the first surface 100a of the substrate 100. By the planarization process, the first mask pattern 103 may be removed and a shallow device isolation pattern 105 filling the first trench T1 may be formed.

A first photoelectric conversion region 110a and a second photoelectric conversion region 110b may be formed in each of the pixel regions PXR. The first photoelectric conversion region 110a and the second photoelectric conversion region 110b may be adjacent to each other in the first direction D1 in each of the pixel regions PXR. The first extensions 150P1 of the deep device isolation pattern 150 may be disposed between the first photoelectric conversion region 110a and the second photoelectric conversion region 110b. The first extensions 150P1 may extend in the second direction D2 between the first and second photoelectric conversion regions 110a and 110b and may be spaced apart from each other in the second direction D2 between the first and second photoelectric conversion regions 110a and 110b. In some embodiments, as described with reference to FIGS. 6 and 7, the second extensions 150P2 of the deep device isolation pattern 150 may extend into the first photoelectric conversion region 110a and the second photoelectric conversion region 110b, respectively. Each of the first photoelectric conversion region 110a and the second photoelectric conversion region 110b may continuously extend in the second direction D2 between the second extensions 150P2.

For example, the formation of the first and second photoelectric conversion regions 110a and 110b may include injecting dopants having a second conductivity type (e.g., an N-type) different from the first conductivity type (e.g., a P-type) into the substrate 100.

A thinning process may be performed on the second surface 100b of the substrate 100, and portions of the substrate 100 and the deep device isolation pattern 150 may be removed by the thinning process. For example, the thinning process may include grinding or polishing and/or anisotropically and/or isotropically etching the second surface 100b of the substrate 100. A lower portion of the deep device isolation pattern 150 may be removed by the thinning process, and a bottom surface 150L of the deep device isolation pattern 150 may be substantially coplanar with the second surface 100b of the substrate 100.

Referring to FIGS. 3, 4, 21A and 21B, a plurality of first transfer gate electrodes TG1, a first floating diffusion region FD1, a plurality of second transfer gate electrodes TG2 and a second floating diffusion region FD2 may be formed on each of the pixel regions PXR and may be formed adjacent to the first surface 100a of the substrate 100. The first transfer gate electrodes TG1 and the first floating diffusion region FD1 may be formed on a corresponding active pattern ACT of the active patterns ACT and may vertically overlap with the first photoelectric conversion region 110a (e.g., in the third direction D3). The second transfer gate electrodes TG2 and the second floating diffusion region FD2 may be formed on a corresponding active pattern ACT of the active patterns ACT and may vertically overlap with the second photoelectric conversion region 110b (e.g., in the third direction D3). In some embodiments, as described with reference to FIGS. 6 and 7, the floating diffusion region FD may be formed on a corresponding active pattern ACT between the first extensions 150P1 of the deep device isolation pattern 150 and between the second extensions 150P2 of the deep device isolation pattern 150, a plurality of first transfer gate electrodes TG1 may be formed to vertically overlap with the first photoelectric conversion region 110a (e.g., in the third direction D3), and a plurality of second transfer gate electrodes TG2 may be formed to vertically overlap with the second photoelectric conversion region 110b (e.g., in the third direction D3).

A lower portion of each of the first and second transfer gate electrodes TG1 and TG2 may penetrate the corresponding active pattern ACT and may extend into the substrate 100. An upper portion of each of the first and second transfer gate electrodes TG1 and TG2 may protrude above a top surface of the corresponding active pattern ACT (i.e., the first surface 100a of the substrate 100). The first and second floating diffusion regions FD1 and FD2 (or the floating diffusion region FD) may be formed by injecting dopants (e.g., N-type dopants) having a second conductivity type different from the first conductivity type of the substrate 100 into the corresponding active pattern ACT.

A first gate dielectric pattern GI1 may be formed between each of the first transfer gate electrodes TG1 and the substrate 100 (i.e., the corresponding active pattern ACT), and a second gate dielectric pattern GI2 may be formed between each of the second transfer gate electrodes TG2 and the substrate 100 (i.e., the corresponding active pattern ACT).

A plurality of gate electrodes GE and source/drain regions SD may be formed on each of the pixel regions PXR and may be formed adjacent to the first surface 100a of the substrate 100. The gate electrodes GE and the source/drain regions SD may be formed on corresponding active patterns ACT and may vertically overlap with the first photoelectric conversion region 110a or the second photoelectric conversion region 110b (e.g., in the third direction D3). The source/drain regions SD may be formed by injecting dopants (e.g., N-type dopants) having the second conductivity type into the corresponding active patterns ACT. A gate dielectric pattern GI may be formed between each of the gate electrodes GE and the substrate 100 (i.e., the corresponding active pattern ACT).

A first interlayer insulating layer 210 may be formed on the first surface 100a of the substrate 100 and may cover the first and second transfer gate electrodes TG1 and TG2 and the gate electrodes GE. A first set of contact plugs 220 may be formed in the first interlayer insulating layer 210 and may penetrate the first interlayer insulating layer 210 so as to be connected to the first and second floating diffusion regions FD1 and FD2 (or the floating diffusion region FD) and the source/drain regions SD. A second interlayer insulating layer 240 may be formed on the first interlayer insulating layer 210. A second set of contact plugs 220 and conductive lines 230 may be formed in the second interlayer insulating layer 240. The second set of contact plugs 220 may penetrate the first interlayer insulating layer 210 and the second interlayer insulating layer 240 so as to be connected to the first and second transfer gate electrodes TG1 and TG2 and the gate electrodes GE. The conductive lines 230 may be connected to the contact plugs 220.

Referring again to FIGS. 3, 4, 5A and 5B, an anti-reflection layer 310 and a first insulating layer 312 may be sequentially formed on the second surface 100b of the substrate 100. A color filter array 320 may be formed on the first insulating layer 312. The color filter array 320 may include a plurality of color filters 320, and the plurality of color filters 320 may be disposed on the plurality of pixel regions PXR, respectively. Each of the plurality of color filters 320 may be formed to vertically overlap with the first and second photoelectric conversion regions 110a and 110b of each of the pixel regions PXR (e.g., in the third direction D3).

A second insulating layer 322 may be formed on the color filter array 320, and a micro lens array 330 may be formed on the second insulating layer 322. The micro lens array 330 may include a plurality of micro lenses 330 disposed on the plurality of color filters 320, respectively. Each of the plurality of micro lenses 330 may be formed to vertically overlap with the first and second photoelectric conversion regions 110a and 110b of each of the pixel regions PXR (e.g., in the third direction D3).

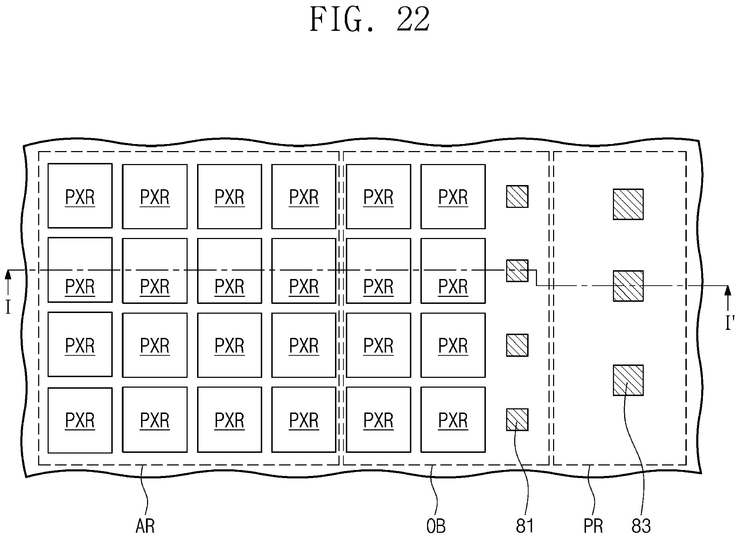

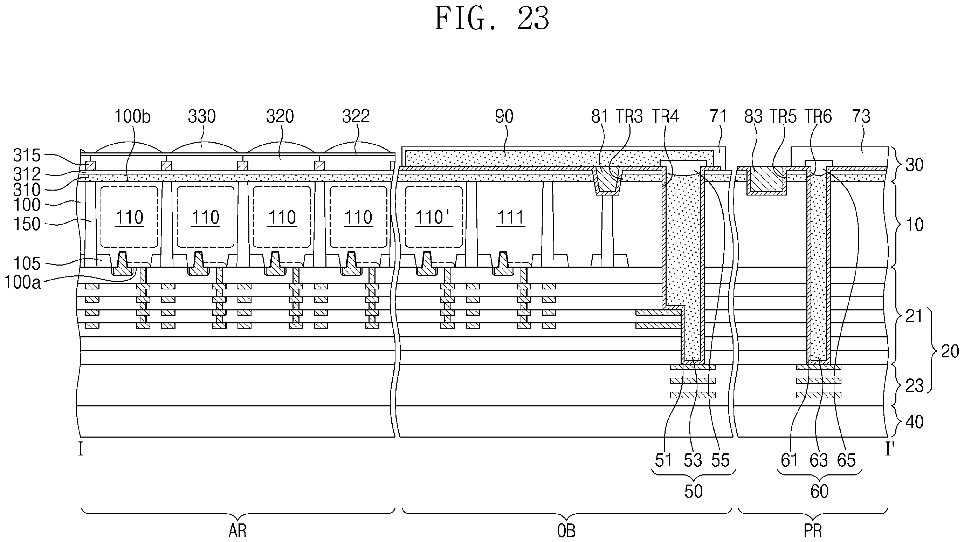

FIG. 22 is a plan view illustrating an image sensor according to some embodiments of the inventive concepts, and FIG. 23 is a cross-sectional view taken along a line I-I' of FIG. 22. Hereinafter, differences between the present embodiments and the above embodiments of FIGS. 3, 4, 5A and 5B will be mainly described for the purpose of ease and convenience in explanation.

Referring to FIGS. 22 and 23, an image sensor may include a substrate 100 including a pixel array region AR, an optical black region OB and a pad region PR, an interconnection layer 20 on a first surface 100a of the substrate 100, a base substrate 40 on the interconnection layer 20, and a light transmitting layer 30 on a second surface 100b of the substrate 100. The interconnection layer 20 may be disposed between the first surface 100a of the substrate 100 and the base substrate 40. The interconnection layer 20 may include an upper interconnection layer 21 adjacent to the first surface 100a of the substrate 100, and a lower interconnection layer 23 between the upper interconnection layer 21 and the base substrate 40. The pixel array region AR may include a plurality of pixel regions PXR, and a deep device isolation pattern 150 disposed therebetween. The pixel array region AR may be substantially the same as at least one of the image sensors described with reference to FIGS. 1 to 18.

A first connection structure 50, a first contact 81 and a bulk color filter 90 may be disposed on the optical black region OB of the substrate 100. The first connection structure 50 may include a first light blocking pattern 51, a first separation pattern 53, and a first capping pattern 55. The first light blocking pattern 51 may be disposed on the second surface 100b of the substrate 100. The first light blocking pattern 51 may cover the first insulating layer 312 and may conformally cover an inner surface of each of a third trench TR3 and a fourth trench TR4. The first light blocking pattern 51 may penetrate the photoelectric conversion layer 10 and the upper interconnection layer 21. The first light blocking pattern 51 may be connected to the semiconductor pattern 152 and 154 of the deep device isolation pattern 150 of the photoelectric conversion layer 10 and may be connected to interconnection lines (or conductive lines) in the upper interconnection layer 21 and the lower interconnection layer 23. Thus, the first connection structure 50 may electrically connect the photoelectric conversion layer 10 and the interconnection layer 20. The first light blocking pattern 51 may include a metal material (e.g., tungsten). The first light blocking pattern 51 may block light incident to the optical black region OB.

The first contact 81 may fill a remaining portion of the third trench TR3. The first contact 81 may include a metal material (e.g., aluminum). The first contact 81 may be connected to the semiconductor pattern 152 and 154 of the deep device isolation pattern 150. A bias may be applied to the semiconductor pattern 152 and 154 through the first contact 81. The first separation pattern 53 may fill a remaining portion of the fourth trench TR4. The first separation pattern 53 may penetrate the photoelectric conversion layer 10 and may penetrate a portion of the interconnection layer 20. The first separation pattern 53 may include an insulating material. The first capping pattern 55 may be disposed on the first separation pattern 53. The first capping pattern 55 may include the same material as the filling insulation pattern 158 of the deep device isolation pattern 150.

The bulk color filter 90 may be disposed on the first connection structure 50 and the first contact 81. The bulk color filter 90 may cover the first connection structure 50 and the first contact 81. A first protective layer 71 may be disposed on the bulk color filter 90 to seal or encapsulate the bulk color filter 90.

An additional photoelectric conversion region 110' and a dummy region 111 may be provided in corresponding pixel regions PXR of the optical black region OB. The additional photoelectric conversion region 110' may be a region doped with dopants (e.g., N-type dopants) having a second conductivity type different from the first conductivity type of the substrate 100. The additional photoelectric conversion region 110' may have a structure similar to that of photoelectric conversion regions 110 (e.g., the first and second photoelectric conversion regions 110a and 110b) in the plurality of pixel regions PXR of the pixel array region AR but may not perform the same operation (i.e., the operation of receiving light to generate an electrical signal) as the photoelectric conversion regions 110. The dummy region 111 may not be doped with dopants.

A second connection structure 60, a second contact 83 and a second protective layer 73 may be disposed on the pad region PR of the substrate 100. The second connection structure 60 may include a second light blocking pattern 61, a second separation pattern 63, and a second capping pattern 65.

The second light blocking pattern 61 may be disposed on the second surface 100b of the substrate 100. The second light blocking pattern 61 may cover the first insulating layer 312 and may conformally cover an inner surface of each of a fifth trench TR5 and a sixth trench TR6. The second light blocking pattern 61 may penetrate the photoelectric conversion layer 10 and the upper interconnection layer 21. The second light blocking pattern 61 may be connected to interconnection lines (or conductive lines) provided in the lower interconnection layer 23. Thus, the second connection structure 60 may electrically connect the photoelectric conversion layer 10 and the interconnection layer 20. The second light blocking pattern 61 may include a metal material (e.g., tungsten). The second light blocking pattern 61 may block light incident to the pad region PR.

The second contact 83 may fill a remaining portion of the fifth trench TR5. The second contact 83 may include a metal material (e.g., aluminum). The second contact 83 may function as an electrical connection path between the image sensor and an external device. The second separation pattern 63 may fill a remaining portion of the sixth trench TR6. The second separation pattern 63 may penetrate the photoelectric conversion layer 10 and may penetrate a portion of the interconnection layer 20. The second separation pattern 63 may include an insulating material. The second capping pattern 65 may be disposed on the second separation pattern 63. The second capping pattern 65 may include the same material as the filling insulation pattern 158 of the deep device isolation pattern 150. The second protective layer 73 may cover the second connection structure 60.

A current applied through the second contact 83 may flow into the semiconductor pattern 152 and 154 of the deep device isolation pattern 150 through the second light blocking pattern 61, the interconnection lines of the interconnection layer 20 and the first light blocking pattern 51. Electrical signals generated from the photoelectric conversion regions 110 (e.g., the first and second photoelectric conversion regions 110a and 110b) in the plurality of pixel regions PXR of the pixel array region AR may be transferred to the external device through the interconnection lines of the interconnection layer 20, the second light blocking pattern 61 and the second contact 83.

According to embodiments of the inventive concepts, each of the pixel regions may include the first photoelectric conversion region and the second photoelectric conversion region which are adjacent to each other, and the deep device isolation pattern may include the first extensions extending between the first photoelectric conversion region and the second photoelectric conversion region, and the second extensions extending into the first photoelectric conversion region and the second photoelectric conversion region, respectively. In this case, each of the pixel regions may include a plurality of photodiodes, and thus the charge storage capacity (or full well capacity) of each of the pixel regions may be increased. In addition, the plurality of first transfer gate electrodes may be disposed on the first photoelectric conversion region, and the plurality of second transfer gate electrodes may be disposed on the second photoelectric conversion region. Thus, the charge transfer characteristics of each of the pixel regions may be improved.

As a result, it is possible to provide the image sensor capable of improving the charge transfer characteristics and the charge storage capacity (or full well capacity) of the unit pixel.

While example embodiments of the inventive concepts have been particularly shown and described, it will be understood by one of ordinary skill in the art that variations in form and detail may be made therein without departing from the scope of the attached claims.

## Claims

1. An image sensor comprising:
a substrate (100) including a pixel region (PXR), the substrate extending in a first direction (D1) and a second direction (D2) intersecting the first direction (D1);
a first photoelectric conversion region (110a) and a second photoelectric conversion region (110b) which are disposed in the pixel region (PXR) of the substrate (100) and are adjacent to each other in the first direction (D1);
a deep device isolation pattern (150) penetrating the substrate in a third direction (D3) perpendicular to the first direction (D1) and the second direction (D2), and surrounding the pixel region (PXR), the deep device isolation pattern (150) comprising first extensions (150P1) extending in the second direction (D2) between the first photoelectric conversion region (110a) and the second photoelectric conversion region (110b), and the first extensions (150P1) spaced apart from each other in the second direction (D2);
a plurality of first transfer gate electrodes (TG1) disposed on the pixel region (PXR) of the substrate (100) and vertically overlapping with the first photoelectric conversion region (110a) in the third direction (D3); and
a plurality of second transfer gate electrodes (TG2) disposed on the pixel region (PXR) of the substrate (100) and vertically overlapping with the second photoelectric conversion region (100b) in the third direction (D3),
wherein the first photoelectric conversion region (110a) extends in the second direction (D2) under the plurality of first transfer gate electrodes (TG1).

2. The image sensor of claim 1, wherein the second photoelectric conversion region (110b) extends in the second direction (D2) under the plurality of second transfer gate electrodes (TG2).

3. The image sensor of claim 1 or 2, wherein a length, in the second direction (D2), of each of the first extensions (150P1) is greater than a distance in the second direction (D2) between the first extensions (150P1).

4. The image sensor of claim 1, 2 or 3, further comprising:
a first floating diffusion region (FD1) and a second floating diffusion region (FD2) which are disposed in the pixel region and are spaced apart from each other in the first direction (D1) with one of the first extensions (150P1) of the deep device isolation pattern (150) interposed therebetween,
wherein the plurality of first transfer gate electrodes (TG1) are disposed adjacent to the first floating diffusion region (FD1), and the plurality of second transfer gate electrodes (TG2) are disposed adjacent to the second floating diffusion region (FD2).

5. The image sensor of any preceding claim, wherein a lower portion of each of the plurality of first transfer gate electrodes (TG1) extends into the substrate (100) toward the first photoelectric conversion region (1 10a) in the third direction (D3), and
wherein a lower portion of each of the plurality of second transfer gate electrodes (TG2) extends into the substrate (100) toward the second photoelectric conversion region (110b) in the third direction (D3).

6. The image sensor of any preceding claim, wherein the deep device isolation pattern (150) further comprises second extensions (150P2) extending in the first direction (D1),
wherein the second extensions (150P2) are spaced apart from each other in the first direction (D1), and
wherein one of the second extensions (150P2) extends into the first photoelectric conversion region (110a), and another of the second extensions (150P2) extends into the second photoelectric conversion region (110b).

7. The image sensor of claim 6, wherein a length, in the first direction, of each of the second extensions (150P2) is equal to or less than a length, in the second direction, of each of the first extensions (150P1).

8. The image sensor of claim 6 or 7, further comprising:
a floating diffusion region (FD) disposed in the pixel region and disposed between the first extensions (150P1) and between the second extensions (150P2),
wherein the plurality of first transfer gate electrodes (TG1) and the plurality of second transfer gate electrodes (TG2) are disposed adjacent to the floating diffusion region (FD).

9. The image sensor of claim 8, wherein one of the plurality of first transfer gate electrodes (TG1) is configured to electrically connect a first portion of the first photoelectric conversion region (1 10a) to the floating diffusion region (FD),
wherein another of the plurality of first transfer gate electrodes (TG1) is configured to electrically connect a second portion of the first photoelectric conversion region (110a) to the floating diffusion region (FD), and
wherein the one of the second extensions (150P2) extends between the first portion and the second portion of the first photoelectric conversion region (1 10a).

10. The image sensor of claim 9, wherein the first portion and the second portion of the first photoelectric conversion region (110a) are continuously connected to each other under the plurality of first transfer gate electrodes (TG1).

11. The image sensor of claim 9 or 10, wherein one of the plurality of second transfer gate electrodes (TG2) is configured to electrically connect a third portion of the second photoelectric conversion region (110b) to the floating diffusion region,
wherein another of the plurality of second transfer gate electrodes (TG2) is configured to electrically connect a fourth portion of the second photoelectric conversion region (110b) to the floating diffusion region, and
wherein the another of the second extensions extends between the third portion and the fourth portion of the second photoelectric conversion region (110b).

12. The image sensor of claim 11, wherein the third portion and the fourth portion of the second photoelectric conversion region (110b) are continuously connected to each other under the second transfer gate electrodes (TG2).

13. The image sensor of any preceding claim, wherein each of the plurality of first transfer gate electrodes (TG1) includes: a lower portion extending into the substrate (100) toward the first photoelectric conversion region (110a) in the third direction (D3); and an upper portion protruding above the substrate (100), and
wherein the upper portions of adjacent first transfer gate electrodes (TG1) of the plurality of first transfer gate electrodes (TG1) are connected to each other.

14. The image sensor of any preceding claim, wherein each of the plurality of second transfer gate electrodes (TG2) includes: a lower portion extending into the substrate (100) toward the second photoelectric conversion region (110b) in the third direction (D3); and an upper portion protruding above the substrate (100), and
wherein the upper portions of adjacent second transfer gate electrodes (TG2) of the plurality of second transfer gate electrodes (TG2) are connected to each other.

## Patentansprüche

1. Bildsensor, Folgendes umfassend:
ein Substrat (100), das einen Pixelbereich (PXR) einschließt, wobei das Substrat sich in einer ersten Richtung (D1) und einer zweiten Richtung (D2), welche die erste Richtung (D1) schneidet, erstreckt;
einen ersten Bereich der fotoelektrischen Umwandlung (110a) und einen zweiten Bereich der fotoelektrischen Umwandlung (110b), die im Pixelbereich (PXR) des Substrats (100) angeordnet sind und in der ersten Richtung (D1) aneinander angrenzen;
ein tiefes Vorrichtungsisolationsmuster (150), das das Substrat in einer dritten Richtung (D3) senkrecht zur ersten Richtung (D1) und zur zweiten Richtung (D2) durchdringt und den Pixelbereich (PXR) umgibt, wobei das tiefe Vorrichtungsisolationsmuster (150) erste Verlängerungen (150P1) umfasst, die sich in der zweiten Richtung (D2) zwischen dem ersten Bereich der fotoelektrischen Umwandlung (110a) und dem zweiten Bereich der fotoelektrischen Umwandlung (110b) erstrecken, und die ersten Verlängerungen (150P1) in der zweiten Richtung (D2) voneinander beabstandet sind;
eine Vielzahl von ersten Transfer-Gate-Elektroden (TG1), die auf dem Pixelbereich (PXR) des Substrats (100) angeordnet sind und sich in der dritten Richtung (D3) mit dem ersten Bereich der fotoelektrischen Umwandlung (110a) vertikal überlappen; und
eine Vielzahl von zweiten Transfer-Gate-Elektroden (TG2), die auf dem Pixelbereich (PXR) des Substrats (100) angeordnet sind und sich in der dritten Richtung (D3) mit dem zweiten Bereich der fotoelektrischen Umwandlung (100b) vertikal überlappen,
wobei der erste Bereich der fotoelektrischen Umwandlung (110a) sich in der zweiten Richtung (D2) unter der Vielzahl von ersten Transfer-Gate-Elektroden (TG1) erstreckt.

2. Bildsensor nach Anspruch 1, wobei der zweite Bereich der fotoelektrischen Umwandlung (110b) sich in der zweiten Richtung (D2) unter der Vielzahl von zweiten Transfer-Gate-Elektroden (TG2) erstreckt.

3. Bildsensor nach Anspruch 1 oder 2, wobei eine Länge jeder der ersten Verlängerungen (150P1) in der zweiten Richtung (D2) größer ist als ein Abstand zwischen den ersten Verlängerungen (150P1) in der zweiten Richtung (D2).

4. Bildsensor nach Anspruch 1, 2 oder 3, ferner Folgendes umfassend:
einen ersten schwebenden Diffusionsbereich (FD1) und einen zweiten schwebenden Diffusionsbereich (FD2), die im Pixelbereich angeordnet sind und in der ersten Richtung (D1) voneinander beabstandet sind, wobei eine der ersten Verlängerungen (150P1) des tiefen Vorrichtungsisolationsmusters (150) dazwischen angeordnet ist,
wobei die Vielzahl von ersten Transfer-Gate-Elektroden (TG1) angrenzend an den ersten schwebenden Diffusionsbereich (FD1) angeordnet ist, und die Vielzahl von zweiten Transfer-Gate-Elektroden (TG2) angrenzend an den zweiten schwebenden Diffusionsbereich (FD2) angeordnet ist.

5. Bildsensor nach einem der vorhergehenden Ansprüche, wobei ein unterer Abschnitt jeder der Vielzahl von ersten Transfer-Gate-Elektroden (TG1) sich in der dritten Richtung (D3) in das Substrat (100) hin zum ersten Bereich der fotoelektrischen Umwandlung (110a) erstreckt, und
wobei ein unterer Abschnitt jeder der Vielzahl von zweiten Transfer-Gate-Elektroden (TG2) sich in der dritten Richtung (D3) in das Substrat (100) hin zum zweiten Bereich der fotoelektrischen Umwandlung (110b) erstreckt.

6. Bildsensor nach einem der vorhergehenden Ansprüche, wobei das tiefe Vorrichtungsisolationsmuster (150) ferner zweite Verlängerungen (150P2) umfasst, die sich in der ersten Richtung (D1) erstrecken,
wobei die zweiten Verlängerungen (150P2) in der ersten Richtung (D1) voneinander beabstandet sind, und
wobei eine der zweiten Verlängerungen (150P2) sich in den ersten Bereich der fotoelektrischen Umwandlung (110a) erstreckt und eine andere der zweiten Verlängerungen (150P2) sich in den zweiten Bereich der fotoelektrischen Umwandlung (110b) erstreckt.

7. Bildsensor nach Anspruch 6, wobei eine Länge jeder der zweiten Verlängerungen (150P2) in der ersten Richtung gleich einer Länge jeder der ersten Verlängerungen (150P1) in der zweiten Richtung oder kleiner ist.

8. Bildsensor nach Anspruch 6 oder 7, ferner Folgendes umfassend:
einen schwebenden Diffusionsbereich (FD), der im Pixelbereich angeordnet ist und zwischen den ersten Verlängerungen (150P1) und zwischen den zweiten Verlängerungen (150P2) angeordnet ist,
wobei die Vielzahl von ersten Transfer-Gate-Elektroden (TG1) und die Vielzahl von zweiten Transfer-Gate-Elektroden (TG2) angrenzend an den schwebenden Diffusionsbereich (FD) angeordnet sind.

9. Bildsensor nach Anspruch 8, wobei eine aus der Vielzahl von ersten Transfer-Gate-Elektroden (TG1) dafür konfiguriert ist, einen ersten Abschnitt des ersten Bereichs der fotoelektrischen Umwandlung (110a) mit dem schwebenden Diffusionsbereich (FD) elektrisch zu verbinden,
wobei eine andere aus der Vielzahl von ersten Transfer-Gate-Elektroden (TG1) dafür konfiguriert ist, einen zweiten Abschnitt des ersten Bereichs der fotoelektrischen Umwandlung (110a) mit dem schwebenden Diffusionsbereich (FD) elektrisch zu verbinden, und
wobei die eine der zweiten Verlängerungen (150P2) sich zwischen dem ersten Abschnitt und dem zweiten Abschnitt des ersten Bereichs der fotoelektrischen Umwandlung (110a) erstreckt.

10. Bildsensor nach Anspruch 9, wobei der erste Abschnitt und der zweite Abschnitt des ersten Bereichs der fotoelektrischen Umwandlung (110a) unter der Vielzahl von ersten Transfer-Gate-Elektroden (TG1) durchgehend miteinander verbunden sind.

11. Bildsensor nach Anspruch 9 oder 10, wobei eine aus der Vielzahl von zweiten Transfer-Gate-Elektroden (TG2) dafür konfiguriert ist, einen dritten Abschnitt des zweiten Bereichs der fotoelektrischen Umwandlung (110b) mit dem schwebenden Diffusionsbereich elektrisch zu verbinden,
wobei eine andere aus der Vielzahl von zweiten Transfer-Gate-Elektroden (TG2) dafür konfiguriert ist, einen vierten Abschnitt des zweiten Bereichs der fotoelektrischen Umwandlung (110b) mit dem schwebenden Diffusionsbereich elektrisch zu verbinden, und
wobei die andere der zweiten Verlängerungen sich zwischen dem dritten Abschnitt und dem vierten Abschnitt des zweiten Bereichs der fotoelektrischen Umwandlung (110b) erstreckt.

12. Bildsensor nach Anspruch 11, wobei der dritte Abschnitt und der vierte Abschnitt des zweiten Bereichs der fotoelektrischen Umwandlung (110b) unter den zweiten Transfer-Gate-Elektroden (TG2) durchgehend miteinander verbunden sind.

13. Bildsensor nach einem der vorhergehenden Ansprüche, wobei jede der Vielzahl von ersten Transfer-Gate-Elektroden (TG1) Folgendes einschließt: einen unteren Abschnitt, der sich in der dritten Richtung (D3) in das Substrat (100) hin zum ersten Bereich der fotoelektrischen Umwandlung (110a) erstreckt; und einen oberen Abschnitt, der über das Substrat (100) hinausragt, und
wobei die oberen Abschnitte von angrenzenden ersten Transfer-Gate-Elektroden (TG1) der Vielzahl von ersten Transfer-Gate-Elektroden (TG1) miteinander verbunden sind.

14. Bildsensor nach einem der vorhergehenden Ansprüche, wobei jede der Vielzahl von zweiten Transfer-Gate-Elektroden (TG2) Folgendes einschließt: einen unteren Abschnitt, der sich in der dritten Richtung (D3) in das Substrat (100) hin zum zweiten Bereich der fotoelektrischen Umwandlung (110b) erstreckt; und einen oberen Abschnitt, der über das Substrat (100) hinausragt, und
wobei die oberen Abschnitte von angrenzenden zweiten Transfer-Gate-Elektroden (TG2) der Vielzahl von zweiten Transfer-Gate-Elektroden (TG2) miteinander verbunden sind.

## Revendications

1. Capteur d'image comprenant :
un substrat (100) incluant une région de pixels (PXR), le substrat s'étendant dans une première direction (D1) et une deuxième direction (D2) intersectant la première direction (D1) ;
une première région de conversion photoélectrique (110a) et une deuxième région de conversion photoélectrique (110b) disposées dans la région de pixels (PXR) du substrat (100) et adjacentes l'une à l'autre dans la première direction (D1) ;
un motif d'isolation de dispositif profond (150) pénétrant dans le substrat dans une troisième direction (D3) perpendiculaire à la première direction (D1) et à la deuxième direction (D2), et entourant la région de pixels (PXR), le motif d'isolation de dispositif profond (150) comprenant des premières extensions (150P1) s'étendant dans la deuxième direction (D2) entre la première région de conversion photoélectrique (110a) et la deuxième région de conversion photoélectrique (110b), et les premières extensions (150P1) étant espacées les unes des autres dans la deuxième direction (D2) ;
une pluralité de premières électrodes de grille de transfert (TG1) disposées sur la région de pixels (PXR) du substrat (100) et se chevauchant verticalement avec la première région de conversion photoélectrique (110a) dans la troisième direction (D3) ; et
une pluralité de deuxièmes électrodes de grille de transfert (TG2) disposées sur la région de pixels (PXR) du substrat (100) et se chevauchant verticalement avec la deuxième région de conversion photoélectrique (100b) dans la troisième direction (D3),
dans lequel la première région de conversion photoélectrique (110a) s'étend dans la deuxième direction (D2) sous la pluralité de premières électrodes de grille de transfert (TG1).

2. Capteur d'image selon la revendication 1, dans lequel la deuxième région de conversion photoélectrique (110b) s'étend dans la deuxième direction (D2) sous la pluralité de deuxièmes électrodes de grille de transfert (TG2).

3. Capteur d'image selon la revendication 1 ou 2, dans lequel une longueur, dans la deuxième direction (D2), de chacune des premières extensions (150P1) est supérieure à une distance dans la deuxième direction (D2) entre les premières extensions (150P1).

4. Capteur d'image selon la revendication 1, 2 ou 3, comprenant en outre :
une première région de diffusion flottante (FD1) et une deuxième région de diffusion flottante (FD2) qui sont disposées dans la région de pixels et sont espacées l'une de l'autre dans la première direction (D1) avec l'une des premières extensions (150P1) du motif d'isolation de dispositif profond (150) interposée entre celles-ci,
dans lequel la pluralité de premières électrodes de grille de transfert (TG1) sont disposées à côté de la première région de diffusion flottante (FD1), et la pluralité de deuxièmes électrodes de grille de transfert (TG2) sont disposées à côté de la deuxième région de diffusion flottante (FD2).

5. Capteur d'image selon l'une quelconque des revendications précédentes, dans lequel une partie inférieure de chaque électrode de la pluralité de premières électrodes de grille de transfert (TG1) s'étend dans le substrat (100) vers la première région de conversion photoélectrique (110a) dans la troisième direction (D3), et
dans lequel une partie inférieure de chaque électrode de la pluralité de deuxièmes électrodes de grille de transfert (TG2) s'étend dans le substrat (100) vers la deuxième région de conversion photoélectrique (110b) dans la troisième direction (D3).

6. Capteur d'image selon l'une quelconque des revendications précédentes, dans lequel le motif d'isolation de dispositif profond (150) comprend en outre des deuxièmes extensions (150P2) s'étendant dans la première direction (D1),
dans lequel les deuxièmes extensions (150P2) sont espacées les unes des autres dans la première direction (D1), et
dans lequel l'une des deuxièmes extensions (150P2) s'étend dans la première région de conversion photoélectrique (110a), et une autre des deuxièmes extensions (150P2) s'étend dans la deuxième région de conversion photoélectrique (110b).

7. Capteur d'image selon la revendication 6, dans lequel une longueur, dans la première direction, de chacune des deuxièmes extensions (150P2) est égale ou inférieure à une longueur, dans la deuxième direction, de chacune des premières extensions (150P1).

8. Capteur d'image selon la revendication 6 ou 7, comprenant en outre :
une région de diffusion flottante (FD) disposée dans la région de pixels et disposée entre les premières extensions (150P1) et entre les deuxièmes extensions (150P2),
dans lequel la pluralité de premières électrodes de grille de transfert (TG1) et la pluralité de deuxièmes électrodes de grille de transfert (TG2) sont disposées de manière adjacente à la région de diffusion flottante (FD).

9. Capteur d'image selon la revendication 8, dans lequel une électrode parmi la pluralité de premières électrodes de grille de transfert (TG1) est configurée pour connecter électriquement une première partie de la première région de conversion photoélectrique (110a) à la région de diffusion flottante (FD),
dans lequel une autre électrode parmi la pluralité de premières électrodes de grille de transfert (TG1) est configurée pour connecter électriquement une deuxième partie de la première région de conversion photoélectrique (110a) à la région de diffusion flottante (FD), et
dans lequel l'une des deuxièmes extensions (150P2) s'étend entre la première partie et la deuxième partie de la première région de conversion photoélectrique (110a).

10. Capteur d'image selon la revendication 9, dans lequel la première partie et la deuxième partie de la première région de conversion photoélectrique (110a) sont connectées en continu l'une à l'autre sous la pluralité de premières électrodes de grille de transfert (TG1).

11. Capteur d'image selon la revendication 9 ou 10, dans lequel une électrode parmi la pluralité de deuxièmes électrodes de grille de transfert (TG2) est configurée pour connecter électriquement une troisième partie de la deuxième région de conversion photoélectrique (110b) à la région de diffusion flottante,
dans lequel une autre électrode parmi la pluralité de deuxièmes électrodes de grille de transfert (TG2) est configurée pour connecter électriquement une quatrième partie de la deuxième région de conversion photoélectrique (110b) à la région de diffusion flottante, et
dans lequel l'autre des deuxièmes extensions s'étend entre la troisième partie et la quatrième partie de la deuxième région de conversion photoélectrique (110b).

12. Capteur d'image selon la revendication 11, dans lequel la troisième partie et la quatrième partie de la deuxième région de conversion photoélectrique (110b) sont connectées en continu l'une à l'autre sous les deuxièmes électrodes de grille de transfert (TG2).

13. Capteur d'image selon l'une quelconque des revendications précédentes, dans lequel chaque électrode de la pluralité de premières électrodes de grille de transfert (TG1) inclut : une partie inférieure s'étendant dans le substrat (100) vers la première région de conversion photoélectrique (110a) dans la troisième direction (D3) ; et une partie supérieure faisant saillie au-dessus du substrat (100), et
dans lequel les parties supérieures des premières électrodes de grille de transfert (TG1) adjacentes de la pluralité de premières électrodes de grille de transfert (TG1) sont connectées les unes aux autres.

14. Capteur d'image selon l'une quelconque des revendications précédentes, dans lequel chaque électrode de la pluralité de deuxièmes électrodes de grille de transfert (TG2) inclut : une partie inférieure s'étendant dans le substrat (100) vers la deuxième région de conversion photoélectrique (110b) dans la troisième direction (D3) ; et une partie supérieure faisant saillie au-dessus du substrat (100), et
dans lequel les parties supérieures des deuxièmes électrodes de grille de transfert (TG2) adjacentes de la pluralité de deuxièmes électrodes de grille de transfert (TG2) sont connectées les unes aux autres.
